# FASCICULE DE BREVET EUROPEEN

(11) **EP 3 479 409 B1**
(45) Date de publication et mention de la délivrance du brevet: **04.08.2021**
(21) Numéro de dépôt: 17742491.8
(22) Date de dépôt: 26.06.2017
(51) Int. Cl.: H01L 27/15, H01L 33/18, H01L 33/24, H01L 33/38

(54) **DISPOSITIF OPTOELECTRONIQUE A DIODES TRIDIMENSIONNELLES**
OPTOELEKTRONISCHE VORRICHTUNG MIT DREIDIMENSIONALEN DIODEN
OPTOELECTRONIC DEVICE COMPRISING THREE-DIMENSIONAL DIODES

(30) Priorité: 30.06.2016 FR 1656218
(43) Date de publication de la demande: 08.05.2019
(73) Titulaire: Aledia, 38040 Grenoble (FR); Commissariat à l'Energie Atomique et aux Energies Alternatives, 75015 Paris (FR)
(72) Inventeur: DUPONT, Florian, 38000 Grenoble (FR); AMSTATT, Benoit, 38000 Grenoble (FR); BEIX, Vincent, 38600 Fontaine (FR); LACAVE, Thomas, 38000 Grenoble (FR); GILET, Philippe, 38470 Teche (FR); HENAFF, Ewen, 38600 Fontaine (FR); HYOT, Bérangère, 38320 Eybens (FR); BONO, Hubert, 38000 Grenoble (FR)
(74) Mandataire: INNOV-GROUP
(86) Numéro de dépôt international: PCT/FR2017/051693
(87) Numéro de publication internationale: WO 2018/002498

(56) Documents cités:
- WO-A1-2014/064276
- WO-A2-2014/056762
- US-A1- 2013 099 199
- US-A1- 2013 112 944
- US-A1- 2015 118 777

## Description

### DOMAINE TECHNIQUE

Le domaine de l'invention est celui des dispositifs optoélectroniques à diodes électroluminescentes ou à photodiodes. L'invention s'applique au domaine des dispositifs à matrice de diodes électroluminescentes tels que les dispositifs d'éclairage, les écrans d'affichage et les projecteurs d'images, ainsi qu'au domaine des dispositifs à matrice de photodiodes tels que les photodétecteurs et les capteurs.

### ÉTAT DE LA TECHNIQUE ANTÉRIEURE

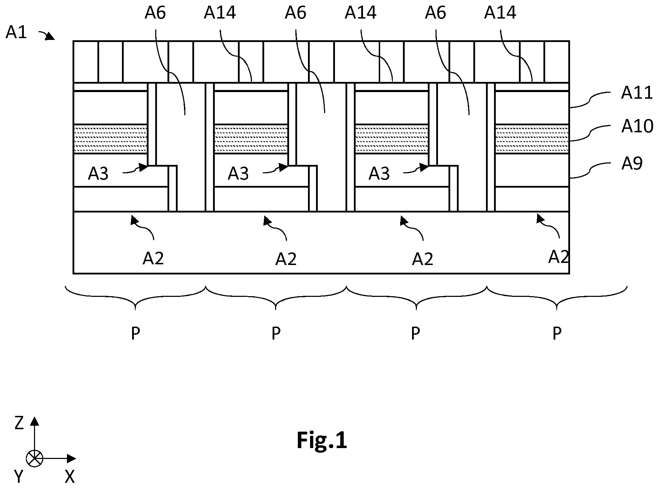

Il existe des dispositifs optoélectroniques à matrice de diodes électroluminescentes adaptées à former des dispositifs d'éclairage, des écrans d'affichage et des projecteurs d'images. Le document EP2960950 illustre un exemple de dispositif optoélectronique à matrice de diodes électroluminescentes. Comme l'illustre de manière schématique la figure 1, ce dispositif optoélectronique A1 comporte une pluralité de diodes électroluminescentes A2 comportant chacune un empilement d'une portion A11 dopée p et d'une portion A9 dopée n séparées l'une de l'autre par une zone active A10 d'où est majoritairement généré le rayonnement lumineux de la diode A2.

Les diodes électroluminescentes A2 présentent une structure dite mesa, c'est-à-dire qu'elles sont obtenues à partir d'un empilement de couches semiconductrices destinées à former les portions A9, A11 dopées n et p ainsi que la zone active A10, une gravure localisée étant effectuée de manière à individualiser les diodes électroluminescentes A2 les unes des autres. Chaque diode A2 comporte une forme en L dont les flancs sont revêtus d'une couche isolante, hormis au niveau d'un décrochement A3 que forme la portion A9 dopée n. Des premières électrodes A14 reposent sur la surface supérieure des portions A11 dopées p et des secondes électrodes A6 s'étendent entre les diodes A2 et viennent au contact des décrochements A3 formés par les portions A9 dopées n. Un pixel d'affichage comporte alors l'empilement des portions dopées A9, A11, de la zone active A10, et de la première électrode A14, ainsi que la seconde électrode A6 adjacente à l'empilement. Une structure de connexion est assemblée à la face supérieure de la matrice de diodes électroluminescentes et est destinée à être hybridée à un circuit intégré de commande.

Ce dispositif optoélectronique comporte cependant l'inconvénient de nécessiter une étape de gravure des couches semiconductrices dopées et de la couche active pour individualiser les diodes. Or cette étape de gravure peut d'entraîner la formation de défauts structuraux susceptibles de dégrader les propriétés optiques et/ou électroniques des diodes. De plus, le rapport entre la surface émissive de chaque diode sur la surface de chaque pixel est réduite par la nécessité de former un décrochement dans la portion dopée n et par la présence de la seconde électrode qui s'étend entre les diodes de manière à venir au contact de ce décrochement. Cela réduit ainsi l'intensité lumineuse maximale relative à chaque pixel.

Le document WO2014/064276 décrit un procédé de fabrication d'un dispositif optoélectronique comportant des diodes filaires épitaxiées à partir de plots de nucléation qui reposent sur un substrat et sont séparés les uns des autres par une zone diélectrique s'étendant dans le substrat.

Le document WO2014/056762 décrit un procédé de fabrication d'un dispositif optoélectronique comportant la suppression du substrat de croissance et la suppression d'une partie haute des diodes pour permettre ensuite de les polariser électriquement au moyen de bandes conductrices.

Le document US2013/112944 décrit un dispositif optoélectronique comportant une pluralité de diodes filaires agencés en pixels distincts, les diodes filaires d'un même pixel étant recouvertes d'une couche conductrice.

### EXPOSÉ DE L'INVENTION

L'invention a pour objectif de remédier au moins en partie aux inconvénients de l'art antérieur, et plus particulièrement de proposer un dispositif optoélectronique comportant :
- un support, comportant des faces opposées dites arrière et avant ;
- une pluralité de bandes conductrices de nucléation formant des premières électrodes de polarisation, distinctes les unes des autres et reposant sur ladite face avant, réalisées en un matériau électriquement conducteur adapté à la croissance de premières portions dopées de diodes ;
- une couche isolante intermédiaire recouvrant les bandes conductrices de nucléation et comportant des ouvertures traversantes débouchant sur les bandes conductrices de nucléation ;
- une pluralité de diodes, chacune comportant une première portion dopée tridimensionnelle et une seconde portion dopée agencées de manière à former une jonction p-n, les premières portions dopées étant au contact des bandes conductrices de nucléation au travers desdites ouvertures traversantes et s'étendant suivant un axe longitudinal sensiblement orthogonal à la face avant ;
- une pluralité de bandes conductrices supérieures formant des secondes électrodes de polarisation, distinctes les unes des autres et reposant sur la couche isolante intermédiaire, chaque bande conductrice supérieure étant agencée de manière à être au contact de secondes portions dopées d'un ensemble de diodes dont les premières portions dopées sont au contact de différentes bandes conductrices de nucléation.

Certains aspects préférés, mais non limitatifs de ce dispositif optoélectronique sont les suivants.

Le support peut comporter un substrat électriquement isolant dont une face supérieure forme ladite face avant, ou peut comporter une couche ou un substrat, semiconducteur ou électriquement conducteur, revêtu d'une couche isolante dite inférieure dont une face forme ladite face avant.

Chaque bande conductrice de nucléation peut s'étendre longitudinalement sur la face avant, en étant électriquement séparée de ses voisines, transversalement, par ladite couche isolante intermédiaire.

Chaque bande conductrice supérieure peut s'étendre longitudinalement sur la couche isolante intermédiaire, en étant électriquement séparée de ses voisines, transversalement, par une couche isolante dite supérieure.

Les bandes conductrices supérieures peuvent être en un matériau conducteur au moins partiellement transparent, et peuvent recouvrir au moins en partie les secondes portions dopées.

Chaque bande conductrice supérieure peut comporter des parties recouvrant les secondes portions dopées d'un ensemble de diodes, lesdites parties dites recouvrantes étant reliées entre elles par des parties dites de liaison reposant sur la couche isolante intermédiaire.

Les parties de liaison des bandes conductrices supérieures peuvent être revêtues au moins en partie par une couche métallique.

Le dispositif optoélectronique peut comporter des premiers plots de connexion reposant sur ladite face arrière, et électriquement connectés aux bandes conductrices de nucléation par des premiers orifices traversant le support et remplis d'un matériau conducteur, et/ou peut comporter des seconds plots de connexion reposant sur ladite face arrière, et électriquement connectés aux bandes conductrices supérieures par des seconds orifices traversant le support et la couche isolante intermédiaire et remplis d'un matériau conducteur.

Le dispositif optoélectronique peut comporter un circuit intégré de commande assemblé au support et électriquement connectés aux bandes conductrices de nucléation et aux bandes conductrices supérieures, adapté à appliquer une différence de potentiel, séquentiellement, à différents sous-ensembles de diodes, la ou les diodes d'un même sous-ensemble étant au contact d'une même bande conductrice de nucléation et d'une même bande conductrice supérieure, la ou les diodes de différents sous-ensembles de diodes étant au contact de différentes bandes conductrices de nucléation et/ou de différentes bandes conductrices supérieures.

Au moins une diode au contact d'une première bande conductrice de nucléation et d'une première bande conductrice supérieure peut être connectée en série avec au moins une autre diode, celle-ci étant au contact d'une deuxième bande conductrice de nucléation distincte de la première bande de nucléation et d'une deuxième bande conductrice supérieure distincte de la première bande supérieure.

Le support peut être formé d'un substrat en un matériau monocristallin formant une surface supérieure, sur laquelle repose une couche isolante dite inférieure en un matériau diélectrique, épitaxié à partir de la surface supérieure du substrat et formant une surface supérieure opposée, les bandes conductrices de nucléation étant en un matériau comportant un métal de transition formant un matériau cristallin de nucléation, épitaxié à partir de la surface supérieure de la couche isolante inférieure et formant une surface de nucléation sur laquelle sont en contact les premières portions dopées desdites diodes.

Le matériau de la couche isolante inférieure peut être choisi parmi le nitrure d'aluminium et les oxydes d'aluminium, de titane, de hafnium, de magnésium et de zirconium, et présente une structure cristalline hexagonale, cubique faces centrées ou orthorhombique.

Le matériau des bandes conductrices de nucléation peut être choisi parmi le titane, le vanadium, le chrome, le zirconium, le niobium, le molybdène, le hafnium, le tantale et le tungstène, ou parmi un nitrure ou un carbure de titane, de vanadium, de chrome, de zirconium, de niobium, de molybdène, de hafnium, de tantale et de tungstène, et présente une structure cristalline hexagonale ou cubique faces centrées. Il peut en variante être un matériau à base de nitrure de gallium, par exemple du GaN, de l'AIGaN, de l'InGaN, ou de l'AlInGaN.

Le matériau monocristallin du substrat peut être choisi parmi un composé III-V, un composé II-VI, ou un élément ou composé IV, et présente une structure cristalline hexagonale ou cubique faces centrées.

L'invention porte également sur un procédé de réalisation du dispositif optoélectronique selon l'une quelconque des caractéristiques précédentes, comportant une étape de croissance épitaxiale des bandes conductrices de nucléation par pulvérisation cathodique à une température de croissance comprise entre la température ambiante et 500°C.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence, outre la figure 1 déjà décrite, aux dessins annexés sur lesquels :

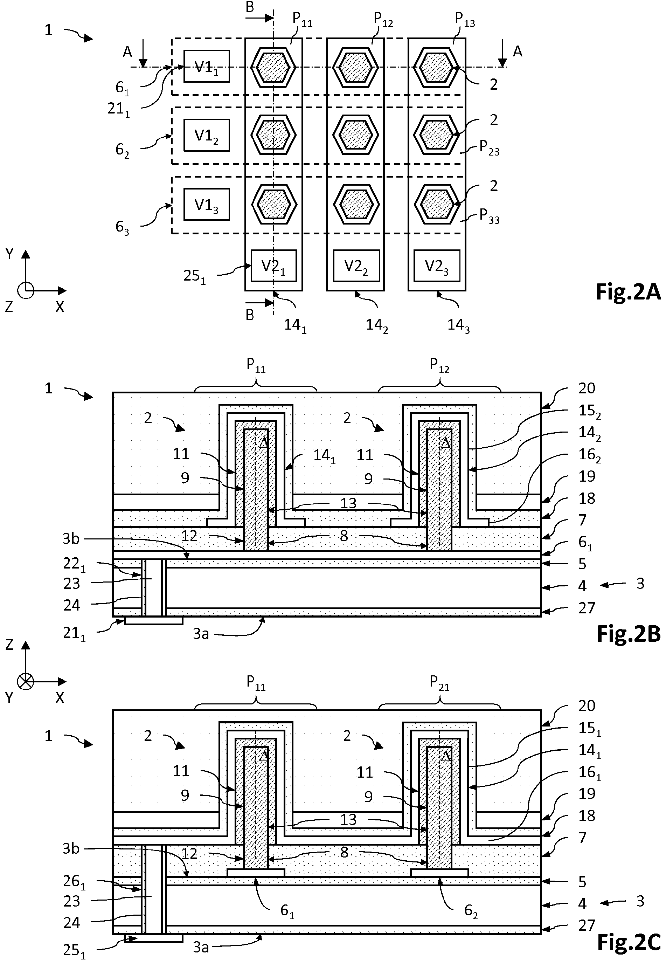

la figure 2A est une vue de dessus, schématique et partielle, d'un dispositif optoélectronique selon un mode de réalisation où une pluralité de diodes est en contact avec des bandes conductrices de nucléation et des bandes conductrices supérieures ; et les figures 2B et 2C sont des vues en coupe, respectivement suivant le plan AA et le plan BB, du dispositif optoélectronique représenté sur la figure 2A ;

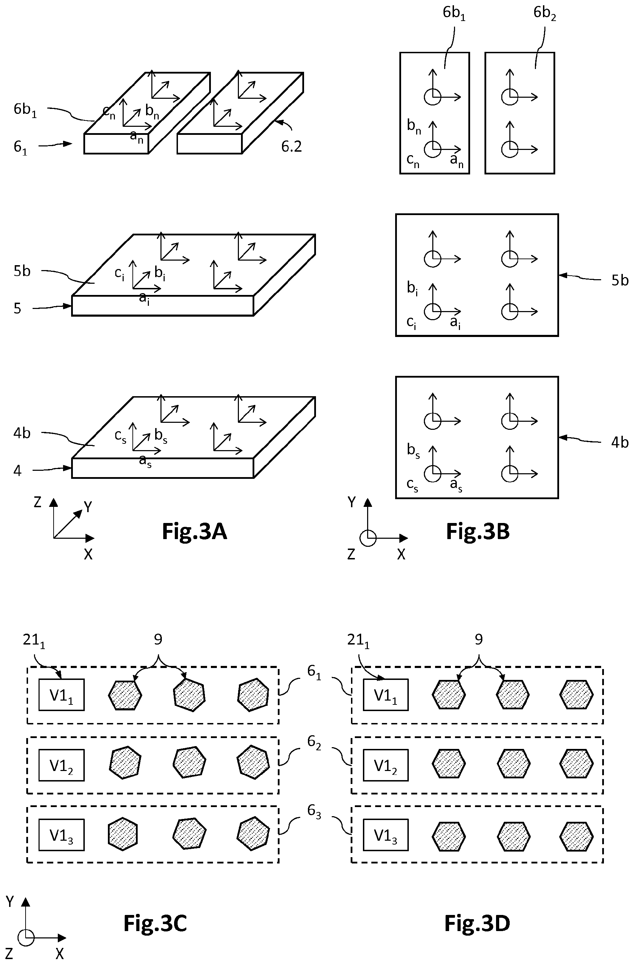

les figures 3A et 3B sont des vues schématiques et partielles, respectivement en éclaté et en perspective, du substrat, de la couche isolante inférieure et des bandes conductrices de nucléation (agencés de bas en haut) d'un dispositif optoélectronique selon un mode de réalisation préféré ; et les figure 3C et 3D sont des vues de dessus de fils épitaxiés sur des surfaces de nucléation texturées (fig.3C) et sur des surfaces de nucléation épitaxiées (fig.3D) ;

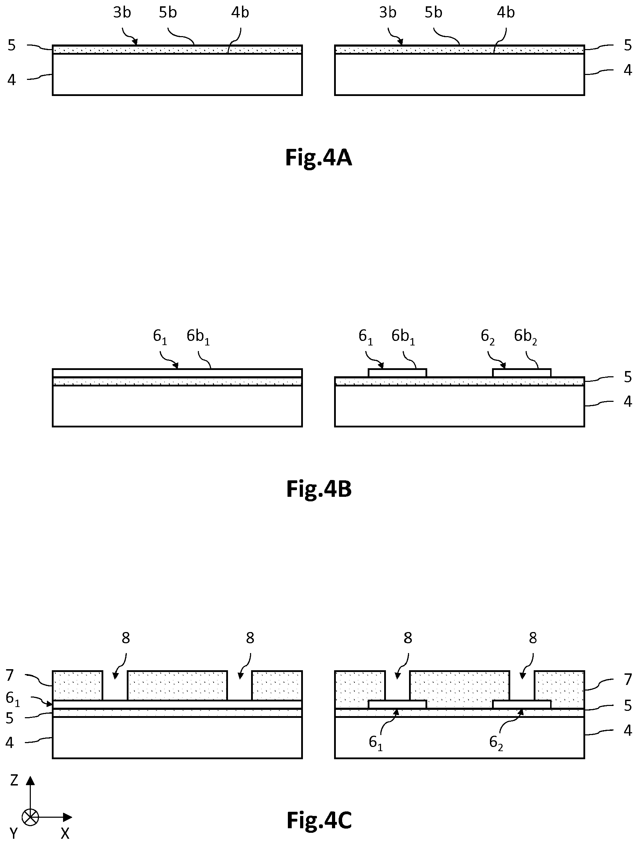

les figures 4A à 4I illustrent des vues en coupe, suivant le plan AA et suivant le plan BB, de différentes étapes d'un procédé de réalisation d'un dispositif optoélectronique selon un autre mode de réalisation ;

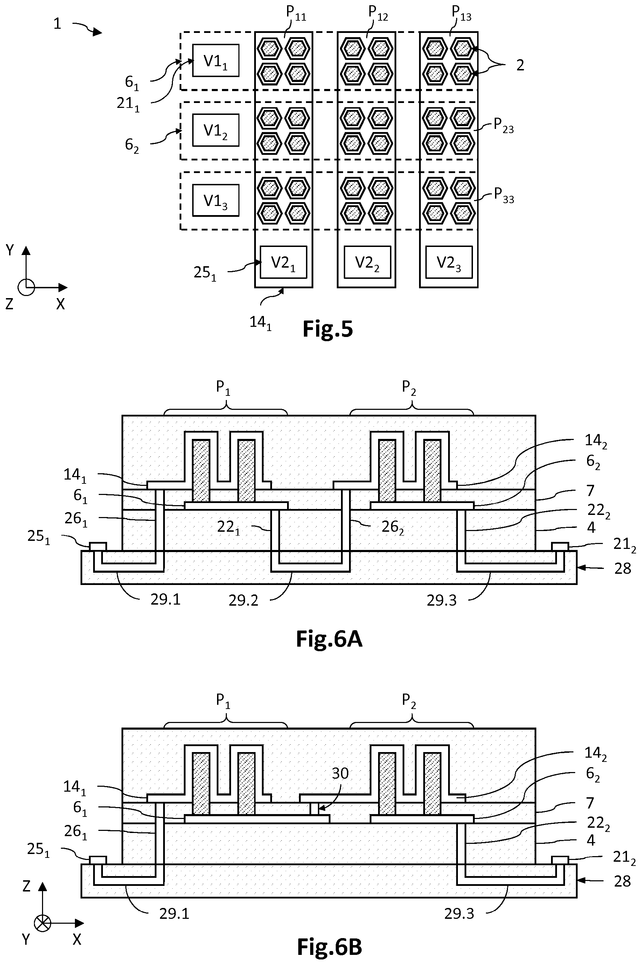

la figure 5 est une vue de dessus, schématique et partielle, d'un dispositif optoélectronique selon un mode de réalisation où chaque pixel comporte plusieurs diodes ;
les figures 6A et 6B sont des vues schématiques et partielles, en coupe transversale, d'un dispositif optoélectronique comportant un circuit intégré de routage comportant des interconnexions électriques de mise en série de pixels (fig.6A) et d'un dispositif optoélectronique comportant des interconnexions électriques internes de mise en série de pixels (fig.6B).

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient « à 10% près » ou, lorsqu'il s'agit d'une orientation angulaire, « à 10° près ».

L'invention porte sur un dispositif optoélectronique à diodes, par exemple des diodes électroluminescentes présentant une forme tridimensionnelle qui comportent chacune une première portion dopée et une seconde portion dopée agencées de manière à former une jonction p-n. Les diodes peuvent être des diodes électroluminescentes adaptées à émettre un rayonnement lumineux ou être des photodiodes adaptées à recevoir un rayonnement lumineux. La forme tridimensionnelle des diodes peut être telle que les diodes présentent une forme filaire, une forme de plot, une forme pyramidale ou autre. Les premières portions dopées des diodes s'étendent suivant un axe longitudinal sensiblement orthogonal au plan principal du support.

Le dispositif optoélectronique comporte des premières électrodes adaptées à porter à un premier potentiel électrique V1 les premières portions dopées des diodes, et des secondes électrodes adaptées à porter à un second potentiel électrique V2 les secondes portions dopées. Les premières électrodes se présentent sous la forme de bandes conductrices de nucléation, distinctes les unes des autres, sur lesquelles reposent et sont en contact les premières portions dopées. Les secondes électrodes se présentent sous la forme de bandes conductrices, dites supérieures, distinctes les unes des autres, au contact des secondes portions dopées.

On définit ici et pour la suite de la description un repère direct tridimensionnel (X,Y,Z), où les axes X et Y forment un plan parallèle au plan principal du substrat, et où l'axe Z est orienté de manière sensiblement orthogonale à la face de croissance du substrat. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'entendent comme étant relatifs à un positionnement croissant lorsqu'on s'éloigne de la face de croissance du substrat suivant la direction +Z.

Par bande conductrice, on entend une étendue d'un matériau semiconducteur ou conducteur, déposé en couche mince, qui présente une dimension longitudinale dans le plan (X,Y), ou longueur, supérieure à la dimension transversale dans le plan (X,Y), ou largeur, et à la dimension d'épaisseur suivant l'axe Z.

Chaque bande conductrice de nucléation d'indice i est au contact d'un ensemble Dᵢ de plusieurs diodes qui sont au contact de différentes bandes conductrices supérieures. De même, chaque bande conductrice supérieure d'indice j est au contact d'un ensemble Dⱼ de plusieurs diodes qui sont au contact de différentes bandes conductrices de nucléation. Ainsi, la ou les diodes qui sont au contact d'une même bande conductrice de nucléation d'indice i et d'une même bande conductrice supérieure d'indice j forment un pixel P d'indices i,j.

Les figures 2A, 2B et 2C sont des vues schématiques et partielles, respectivement en vue de dessus, en coupe transversale suivant le plan AA et suivant le plan BB, d'un dispositif optoélectronique 1 à diodes électroluminescentes 2 selon un premier mode de réalisation.

Le dispositif optoélectronique 1 comporte :
- un support 3, comportant des faces opposées dites arrière 3a et avant 3b ;
- une pluralité de premières électrodes sous la forme de bandes conductrices 6ᵢ dites de nucléation, distinctes les unes des autres et reposant sur ladite face avant 3b, réalisées en un matériau électriquement conducteur adapté à la croissance des premières portions dopées 9 de diodes 2 ;
- une couche isolante intermédiaire 7 recouvrant les bandes conductrices de nucléation 6ᵢ et comportant des ouvertures traversantes 8 débouchant sur les bandes conductrices de nucléation 6ᵢ ;
- une pluralité de diodes 2, chacune comportant une première portion dopée 9 tridimensionnelle et une seconde portion dopée 11 agencées de manière à former une jonction p-n, les premières portions dopées 9 étant au contact des bandes conductrices de nucléation 6ᵢ au travers desdites ouvertures traversantes 8 et s'étendant suivant un axe longitudinal Δ sensiblement orthogonal à la face avant 3b ;
- une pluralité de secondes électrodes sous la forme de bandes conductrices dites supérieures 14ⱼ, distinctes les unes des autres et reposant sur la couche isolante intermédiaire 7, chaque bande conductrice supérieure 14ⱼ étant agencée de manière à être au contact de secondes portions dopées 11 d'un ensemble Dⱼ de diodes 2 dont les premières portions dopées 9 sont au contact de différentes bandes conductrices de nucléation 6ᵢ.

Comme détaillé plus loin, la ou les diodes 2, au contact d'une bande conductrice de nucléation 6 d'indice i et au contact d'une bande conductrice supérieure 14 d'indice j, forment un pixel émissif Pᵢⱼ. Ainsi, une pluralité de pixels émissifs Pᵢⱼ est formée par l'agencement des premières et des secondes électrodes en plusieurs bandes conductrices distinctes les unes des autres. Dans cet exemple, chaque pixel Pᵢⱼ comporte une unique diode, mais il peut comporter en variante une pluralité de diodes. En d'autres termes, chaque bande conductrice de nucléation 6ᵢ est au contact d'un ensemble Dᵢ de diodes, réparties en sous-ensembles Pᵢⱼ distincts les uns des autres. Chaque sous-ensemble Pᵢⱼ de diodes d'une même bande conductrice de nucléation 6ᵢ est au contact d'une même bande conductrice supérieure 14 d'indice j et forme un pixel Pᵢⱼ.

Le support 3 comporte deux faces, dites avant 3b et arrière 3a, opposées l'une à l'autre. Il peut être une structure monobloc, ou être formé d'un empilement de couches tel qu'un substrat 4 de type SOI (pour *Silicon On Insulator,* en anglais). Il comporte un matériau électriquement isolant au niveau de la face avant 3b. Il peut ainsi être formé, par exemple, d'un substrat 4 monobloc isolant, ou être formé d'un substrat 4 semiconducteur ou conducteur dont la face supérieure est revêtue d'une couche isolante 5.

Le matériau du substrat 4 peut être électriquement isolant, tel que par exemple un oxyde de silicium (par exemple SiO2) ou du saphir, ou être un matériau semiconducteur par exemple choisi parmi les composés III-V comportant au moins un élément de la colonne III et au moins un élément de la colonne V du tableau périodique, les composés II-VI ou les éléments ou composés IV. A titre d'exemple, il peut s'agir du silicium, du germanium, du carbure de silicium. De préférence, le matériau semiconducteur du substrat 4 est du silicium monocristallin.

Le substrat 4 peut présenter une épaisseur comprise entre 50nm et 1500µm, selon qu'il a été aminci ou non. Dans cet exemple où le support a été aminci dans le but de permettre une reprise de contact électrique en face arrière 3a, il présente une épaisseur par exemple comprise entre 10µm et 300µm, de préférence comprise entre 10µm et 100µm. Dans le cas où il n'a pas été aminci, notamment lorsque la reprise de contact est assurée en face avant 3b, il présente une épaisseur comprise entre 300µm et 1500µm, par exemple égale à 725µm environ.

Dans cet exemple, le support est formé d'un substrat semiconducteur 4 dont la face supérieure est revêtue d'une couche isolante dite inférieure 5 en un matériau diélectrique. La couche isolante inférieure 5 assure une isolation électrique entre les bandes conductrices de nucléation 6ᵢ et le substrat 4 lorsque ce dernier est électriquement conducteur. Le matériau de la couche isolante inférieure 5 peut être un oxyde de silicium (par exemple SiO2) ou d'aluminium (par exemple Al2O3), un nitrure de silicium SiNx ou d'aluminium AIN, un oxynitrure de silicium SiOxNy, ou tout autre matériau adapté. L'épaisseur de la couche isolante inférieure 5 peut être comprise entre 5nm et 500nm, de préférence comprise entre 10nm et 100nm, par exemple égale à 30nm environ.

En variante (non représentée), le substrat peut être supprimé et le support peut alors être formé d'une couche déposée, par exemple une couche réflectrice, éventuellement métallique, permettant la réflexion du rayonnement lumineux incident émis par les diodes 2. Les étapes de suppression du substrat et de dépôt de la couche du support peuvent être réalisées après la réalisation des diodes.

Les premières électrodes de polarisation sont agencées de manière à permettre l'application d'un premier potentiel électrique V1ᵢ à différents ensembles de diodes. Elles prennent la forme d'une pluralité de bandes conductrices de nucléation 6ᵢ qui reposent sur la face avant 3b du support, ici la face supérieure de la couche isolante inférieure 5. Chaque bande conductrice de nucléation 6ᵢ présente une face supérieure, opposée à la face avant 3b du support, qui forme une surface de nucléation sur laquelle chaque première portion dopée 9 de diode 2 est en contact. Les bandes conductrices de nucléation 6ᵢ sont distinctes les unes des autres et peuvent présenter un potentiel électrique V1ᵢ qui varie dans le temps, dont la valeur peut être différente d'une bande à l'autre. Elles peuvent s'étendre longitudinalement dans le plan (X,Y) de manière rectiligne ou courbe, parallèlement les unes aux autres. Chaque bande conductrice de nucléation 6 d'indice i est au contact d'un ensemble Dᵢ de diodes au niveau des premières portions dopées 9 de celles-ci, les ensembles de diodes étant différents d'une bande conductrice de nucléation 6ᵢ à l'autre.

Les bandes conductrices de nucléation 6ᵢ sont réalisées en un matériau électriquement conducteur adapté à la nucléation et la croissance des premières portions dopées 9. Ce matériau peut être du nitrure de gallium GaN, ou un alliage à base de nitrure de gallium, par exemple du nitrure de gallium et d'aluminium AlGaN, du nitrure de gallium et d'indium InGaN, voire du nitrure de gallium, d'aluminium et d'indium AlInGaN. Les bandes conductrices de nucléation 6ᵢ peuvent en variante être en un matériau comportant un métal de transition. Il peut être choisi parmi le titane, le vanadium, le chrome, le zirconium, le niobium, le molybdène, le hafnium, le tantale et le tungstène, ou en un nitrure ou un carbure de métal de transition, par exemple de titane, de zirconium, de hafnium, de vanadium, de niobium, de tantale, de chrome, de molybdène, de tantale, ou en une combinaison de ces composés. Les métaux de transition, ainsi que leurs nitrures et carbures, présentent les avantages de permettre la nucléation des premières portions dopées 9 et d'avoir une conductivité électrique proche de celle des métaux. Les bandes conductrices de nucléation 6ᵢ présentent une épaisseur par exemple comprise entre 5nm et 500nm, de préférence comprise entre 10nm et 100nm, par exemple égale à 30nm environ. Elles présentent une dimension transversale dans le plan (X,Y), ou largeur, par exemple comprise entre 20nm et 50µm, de préférence comprise entre 200nm et 10µm, de préférence comprise entre 800nm et 5µm, par exemple égale à 1µm environ. Les bandes conductrices de nucléation 6ᵢ sont espacées transversalement les unes des autres d'une distance par exemple comprise entre 500nm et 20µm, de préférence entre 1000nm et 2000nm, par exemple égale à 1500nm.

Le dispositif optoélectronique 1 comporte en outre une couche isolante dite intermédiaire 7 qui recouvre la face avant 3b du support, et recouvre en particulier les bandes conductrices de nucléation 6ᵢ. Elle forme un masque de croissance autorisant la croissance épitaxiale des premières portions dopées 9 des diodes à partir d'ouvertures traversantes 8 débouchant localement sur les surfaces de nucléation. De plus, elle s'étend de manière à séparer chaque bande conductrice de nucléation 6ᵢ, transversalement, de ses voisines. Elle participe également à assurer l'isolation électrique entre les bandes conductrices de nucléation 6ᵢ et les bandes conductrices supérieures 14ⱼ. La couche isolante intermédiaire 7 est réalisée en un ou plusieurs matériaux diélectriques tels que, par exemple, un oxyde de silicium (par exemple SiO2) ou un nitrure de silicium (par exemple Si3N4 ou SiN), voire un oxynitrure de silicium, un oxyde d'aluminium (par exemple Al2O3) ou un oxyde de hafnium (par exemple HfO2). L'épaisseur de la couche isolante intermédiaire 7 peut être comprise entre 5nm et 500nm, de préférence comprise entre 30nm et 300nm, par exemple égale à 100nm environ.

Chaque diode électroluminescente 2 comporte une première portion dopée 9, de forme tridimensionnelle. Dans ce mode de réalisation, les premières portions dopées 9 présentent une forme allongée suivant un axe longitudinal Δ, c'est-à-dire dont la dimension longitudinale suivant l'axe longitudinal Δ est supérieure aux dimensions transversales. Les premières portions dopées 9 sont alors appelées « fils », « nanofils » ou « microfils ». Les dimensions transversales des fils 9, c'est-à-dire leurs dimensions dans un plan orthogonal à l'axe longitudinal Δ, peuvent être comprises entre 10nm et 10µm, par exemple comprises entre 100nm et 10µm, et de préférence comprises entre 100 nm et 5µm. La hauteur des fils 9, c'est-à-dire leur dimension longitudinale suivant l'axe longitudinal Δ, est supérieure aux dimensions transversales, par exemple 2 fois, 5 fois et de préférence au moins 10 fois supérieure. La section droite des fils 9, dans un plan orthogonal à l'axe longitudinal Δ, peut présenter différentes formes, par exemple une forme circulaire, ovale, polygonale par exemple triangulaire, carrée, rectangulaire voire hexagonale. On définit ici le diamètre comme étant une grandeur associée au périmètre du fil au niveau d'une section droite. Il peut s'agir du diamètre d'un disque présentant la même surface que la section droite du fil. Le diamètre local est le diamètre du fil à une hauteur donnée de celui-ci suivant l'axe longitudinal Δ. Le diamètre moyen est la moyenne, par exemple arithmétique, des diamètres locaux le long du fil ou d'une portion de celui-ci.

Chaque première portion dopée 9 s'étend à partir de la surface de nucléation d'une bande conductrice de nucléation 6ᵢ, suivant un axe longitudinal Δ orienté de manière sensiblement orthogonale au plan (X,Y). Chaque diode 2 comporte en outre une zone active et une seconde portion dopée 11. Le fil 9 forme ici le cœur d'une diode électroluminescente 2 en configuration cœur/coquille, la zone active et la seconde portion dopée 11 recouvrant la bordure latérale d'une partie 13 dite supérieure du fil 9. Les fils 9 comportent une partie inférieure 12 qui est au contact des surfaces de nucléation et est entourée par la couche isolante intermédiaire 7. Cette partie inférieure 12 se prolonge par la partie supérieure 13 qui est située hors des ouvertures 8 de croissance et est recouverte par la zone active et la seconde portion dopée 11.

Les fils 9 peuvent être réalisés en un matériau cristallin épitaxié à partir de la surface de nucléation. Le matériau des fils 9 comporte majoritairement un premier composé semiconducteur qui peut être choisi parmi les composés III-V et en particulier parmi les composés III-N, parmi les composés II-VI ou parmi les composés ou éléments IV. A titre d'exemple, des composés III-V peuvent être des composés tels que GaN, InGaN, AIGaN, AIN, InN ou AlInGaN, voire des composés tels que l'AsGa ou l'InP. Des composés II-VI peuvent être CdTe, HgTe, CdHgTe, ZnO, ZnMgO, CdZnO, CdZnMgO. Des éléments ou composés IV peuvent être Si, C, Ge, SiC, SiGe, GeC. Les fils 9 forment ainsi les premières portions des diodes, et sont dopés selon un premier type de conductivité, ici de type n. Dans cet exemple, les fils 9 sont en GaN dopé de type n, notamment par du silicium. Ils présentent ici un diamètre moyen compris entre 10nm et 10µm, par exemple compris entre 500nm et 5µm et est ici sensiblement égal à 500nm. La hauteur des fils 9 peut être comprise entre 100nm et 100µm, par exemple comprise entre 500nm et 50µm, et est ici sensiblement égale à 5µm.

La zone active est la portion de la diode 2 au niveau de laquelle est émis l'essentiel du rayonnement lumineux de la diode. Elle peut comprendre au moins un puits quantique réalisé en un composé semiconducteur présentant une énergie de bande interdite inférieure à celles du fil 9 et de la seconde portion dopée 11. Elle recouvre ici la bordure supérieure et la bordure latérale du fil 9. Elle peut comporter un unique puits quantique ou une pluralité de puits quantiques sous forme de couches ou de boîtes intercalées entre des couches barrières. De manière alternative, la zone active peut ne pas comporter de puits quantique. Elle peut présenter une énergie de bande interdite sensiblement égale à celle du fil 9 et de la seconde portion dopée 11. Elle peut être réalisée en un composé semiconducteur non intentionnellement dopé.

La seconde portion dopée 11 forme une couche qui recouvre et entoure au moins en partie la zone active. Elle est réalisée en un second composé semiconducteur dopé selon un second type de conductivité opposé au premier type, c'est-à-dire ici de type p. Le second composé semiconducteur peut être identique au premier composé semiconducteur du fil ou peut comporter le premier composé semiconducteur et en outre un ou plusieurs éléments supplémentaires. Dans cet exemple, la seconde portion dopée 11 peut être du GaN ou de l'InGaN, dopé de type p notamment par du magnésium. L'épaisseur de la seconde portion dopée 11 peut être comprise entre 20nm et 500nm, et peut être égale à 150nm environ. Bien entendu, les types de conductivité des première et seconde portions 9, 11 peuvent être inversés.

La seconde portion dopée 11 peut comporter en outre une couche intercalaire de blocage d'électrons (non représentée) située à l'interface avec la zone active. La couche de blocage d'électrons peut ici être formée d'un composé ternaire III-N, par exemple de l'AIGaN ou de l'AlInN, avantageusement dopé p. Elle permet d'accroître le taux de recombinaisons radiatives dans la zone active.

Les secondes électrodes de polarisation 14ⱼ sont agencées de manière à permettre l'application d'un second potentiel électrique V2ⱼ à différents ensembles de diodes. Elles prennent la forme d'une pluralité de bandes conductrices dites supérieures 14ⱼ qui reposent sur la face supérieure de la couche isolante intermédiaire 7. Elles sont distinctes les unes des autres et peuvent présenter un potentiel électrique V2ⱼ qui varie dans le temps, dont la valeur peut être différente d'une bande à l'autre. Elles sont en outre électriquement séparées des bandes conductrices de nucléation 6i par la couche isolante intermédiaire 7. Elles peuvent s'étendre longitudinalement dans le plan (X,Y) de manière rectiligne ou courbe, parallèlement les unes aux autres. Dans ce mode de réalisation, chaque bande conductrice supérieure 14ⱼ s'étend longitudinalement et comporte des parties 15ⱼ recouvrant les secondes portions dopées 11 desdites diodes 2 qui sont reliées entre elles par des parties 16ⱼ dites de liaison s'étendant de manière sensiblement plane sur la face supérieure de la couche isolante intermédiaire 7.

Chaque bande conductrice supérieure 14 d'indice j est au contact d'un ensemble Dⱼ de diodes 2 au niveau des secondes portions dopées 11 de celles-ci, les ensembles Dⱼ de diodes 2 étant différents d'une bande conductrice supérieure 14ⱼ à l'autre. Les bandes conductrices supérieures 14ⱼ s'étendent transversalement aux bandes conductrices de nucléation 6ᵢ, de sorte qu'un ensemble Dᵢ de diodes 2 au contact d'une bande conductrice de nucléation 6 d'indice i ne soit pas identique à un ensemble Dⱼ de diodes 2 au contact d'une bande conductrice supérieure 14ⱼ. L'intersection entre un ensemble Dᵢ de diodes 2 d'une bande conductrice de nucléation 6 d'indice i avec un ensemble Dⱼ de diodes 2 d'une bande conductrice supérieure 14 d'indice j forme un pixel Pᵢⱼ.

Les bandes conductrices supérieures 14ⱼ sont réalisées en un matériau électriquement conducteur, et, lorsqu'elles recouvrent les secondes portions dopées 11, avantageusement transparent au rayonnement lumineux émis par les diodes. Il peut s'agir, par exemple, d'un oxyde d'indium étain (ITO, pour *Indium Tin Oxide* en anglais) ou d'un oxyde de zinc dopé au gallium (GZO, pour *Gallium doped Zinc Oxide* en anglais), voire dopé à l'aluminium ou à l'indium. Par transparent, ou au moins partiellement transparent, on entend un matériau qui transmet au moins 50% de la lumière incidente, et de préférence au moins 80% voire davantage.

Les bandes conductrices supérieures 14ⱼ présentent une épaisseur par exemple comprise entre 5nm et 500nm, de préférence comprise entre 10nm et 100nm, par exemple égale à 50nm environ. Elles présentent une dimension transversale dans le plan (X,Y), ou largeur, par exemple comprise entre 20nm et 50µm, de préférence comprise entre 200nm et 10µm, de préférence comprise entre 800nm et 5µm, par exemple égale à 1,5µm environ. La largeur est telle que chaque bande conductrice supérieure 14ⱼ est séparée électriquement de ses voisines. La longueur des bandes conductrices supérieures 14ⱼ est telle que chaque bande conductrice supérieure 14ⱼ est au contact des secondes portions dopées 11 d'un ensemble de diodes 2 qui sont au contact de différentes bandes conductrices de nucléation 6ᵢ. Les bandes conductrices supérieures 14ⱼ sont espacées transversalement les unes des autres d'une distance par exemple comprise entre 1000nm et 10µm, de préférence entre 1000nm et 3000nm, par exemple égale à 2500nm.

Dans ce mode de réalisation, une couche isolante dite supérieure 18, et au moins partiellement transparente recouvre de manière conforme les bandes conductrices supérieures 14ⱼ et la face supérieure de la couche isolante intermédiaire 7. Elle peut être en un matériau diélectrique transparent au rayonnement lumineux émis par les diodes, par exemple, un oxyde de silicium (par exemple SiO2) ou d'aluminium (par exemple Al2O3), un nitrure de silicium SiNx ou d'aluminium AIN, un oxynitrure de silicium SiOxNy, ou tout autre matériau adapté. Elle présente une épaisseur par exemple comprise entre 5nm et 500nm, de préférence comprise entre 50nm et 300nm, par exemple égale à 100nm environ.

Dans cet exemple, une couche réflectrice 19 est présente entre les diodes 2 et repose sur la couche isolante supérieure 18 sans toutefois recouvrir les fils 9. Elle est réalisée en un matériau adapté à réfléchir le rayonnement lumineux incident émis par les diodes 2 en direction de l'extérieur du dispositif optoélectronique 1, suivant la direction +Z. Le matériau peut être un métal, par exemple de l'aluminium, de l'argent, de l'or, du cuivre, ou une combinaison de ceux-ci, ou tout autre matériau adapté. La couche réflectrice 19 présente une épaisseur par exemple comprise entre 10nm et 2µm, de préférence comprise entre 100nm et 500nm, par exemple égale à 200nm environ.

Dans cet exemple, une couche d'encapsulation 20 recouvre les diodes. Elle est réalisée en un matériau diélectrique au moins partiellement transparent au rayonnement lumineux émis par les diodes, et peut être, par exemple, un oxyde de silicium (par exemple SiO2) ou d'aluminium (par exemple Al2O3), un nitrure de silicium SiNx ou d'aluminium AIN, un oxynitrure de silicium SiOxNy, ou tout autre matériau adapté. L'épaisseur de la couche d'encapsulation 20 est telle qu'elle recouvre les diodes, notamment à leur sommet. Elle est comprise, par exemple, entre 500nm et 50µm.

Comme représenté sur la figure 2B, le dispositif optoélectronique 1 comporte également une pluralité de premiers plots de connexion 21ᵢ chacun étant électriquement relié à une bande conductrice de nucléation 6ᵢ. Les premiers plots de connexion 21ᵢ peuvent être situés en face avant 3b ou en face arrière 3a du support. Dans cet exemple, la connexion électrique est effectuée en face arrière 3a du support. Pour cela, des premiers orifices traversants 22ᵢ s'étendent entre les faces avant 3b et arrière 3a du support et débouchent chacun sur une bande conductrice de nucléation 6ᵢ. Les orifices traversants 22ᵢ sont remplis d'un matériau conducteur 23 et sont en contact, d'une part avec le matériau de la bande conductrice de nucléation 6ᵢ et d'autre part avec un premier plot de connexion 21ᵢ. Dans le but d'isoler, le cas échéant, le matériau du substrat 4 semiconducteur ou conducteur, les flancs des orifices traversants 22ᵢ sont revêtus d'une couche isolante 24. Le matériau de remplissage 23 et celui des premiers plots de connexion 21ᵢ peuvent être en cuivre, or, aluminium ou en tout autre matériau conducteur adapté.

Comme représenté sur la figure 2C, le dispositif optoélectronique 1 comporte également une pluralité de seconds plots de connexion 25ⱼ chacun étant électriquement relié à une bande conductrice supérieure 14ⱼ. Les seconds plots de connexion 25ⱼ peuvent être situés en face avant 3b ou en face arrière 3a du support. Dans cet exemple, la connexion électrique est effectuée en face arrière 3a du support. Pour cela, des seconds orifices traversants 26ⱼ s'étendent entre les faces avant 3b et arrière 3a du support et débouchent chacun sur une bande conductrice supérieure 14ⱼ. Les orifices traversants 26ⱼ sont remplis d'un matériau conducteur 23 et sont en contact, d'une part avec le matériau de la bande conductrice supérieure 14ⱼ et d'autre part avec un second plot de connexion 25ⱼ. Dans le but d'isoler, le cas échéant, le matériau conducteur du substrat 4 semiconducteur, les flancs des orifices traversants 26ⱼ sont revêtus d'une couche isolante 24. Le matériau de remplissage 23 et celui des seconds plots de connexion 25ⱼ peuvent être en cuivre, or, aluminium ou en tout autre matériau conducteur adapté.

Une couche isolante 27 peut recouvrir la face arrière 3a du support de manière à isoler électriquement les premiers et seconds plots de connexion 21ᵢ et 25ⱼ vis-à-vis du matériau du substrat 4.

Le dispositif optoélectronique 1 comporte un circuit intégré de commande (non représenté) assemblé au support, et raccordé électriquement aux bandes conductrices de nucléation 6ᵢ par l'intermédiaire des premiers plots de connexion 21ᵢ, et aux bandes conductrices supérieures 14ⱼ par l'intermédiaire des seconds plots de connexion 25ⱼ. Le circuit intégré de commande peut comporter des composants électroniques, par exemple des transistors, de manière à commander l'application d'une différence de potentiel électrique, de manière simultanée ou séquentielle, aux différents pixels Pᵢⱼ de diodes.

L'hybridation du circuit de commande au support peut être effectuée par collage direct (ou collage par adhésion moléculaire, *direct bonding* en anglais) de type métal-métal et diélectrique-diélectrique. Elle peut en variante être effectuée par des éléments de connexion intermédiaire en un matériau conducteur fusible, tels que des billes d'indium, venant au contact des différents premiers et seconds plots de connexion du dispositif optoélectronique 1. En variante, le circuit de commande peut être connecté aux premiers et seconds plots de connexion 21ᵢ et 25ⱼ par l'intermédiaire de fils électriques soudés (*wire bonding,* en anglais), notamment lorsque les plots de connexion sont situés sur la face avant 3b du support.

En fonctionnement, lorsqu'un premier potentiel électrique V1ᵢ est appliqué à la bande conductrice de nucléation 6ᵢ et un second potentiel électrique V2ⱼ est appliqué à la bande conductrice supérieure 14ⱼ, la ou les diodes 2 situées dans le pixel Pᵢⱼ sont activées et émettent un rayonnement lumineux. Les diodes 2 situées dans les autres pixels restent désactivées. Ainsi, l'émission contrôlée de chaque pixel Pᵢⱼ, de manière simultanée ou séquentielle, est effectuée en polarisant l'une ou l'autre des bandes conductrices de nucléation 6i et l'une ou l'autre des bandes conductrices supérieures 14j.

Ainsi, le dispositif optoélectronique 1 comporte une pluralité de diodes 2 réparties en une matrice de pixels activables les uns indépendamment des autres aux moyens des premières et secondes électrodes de polarisation qui se présentent sous la forme de bandes conductrices distinctes les unes des autres. De plus, le fait que les premières électrodes de polarisation présentent une fonction supplémentaire de surface de nucléation permet de simplifier la structure ainsi que le procédé de réalisation. Chaque pixel peut en outre comporter une surface développée de la zone active sensiblement égale ou supérieure à la surface, dans le plan (X,Y), du pixel, de sorte que l'intensité maximale d'émission lumineuse du dispositif optoélectronique 1 peut être supérieure à celle du dispositif optoélectronique 1 de l'art antérieur mentionné précédemment. On obtient ainsi un dispositif optoélectronique 1 à haute intensité lumineuse et à haute résolution.

Selon un mode de réalisation préféré, les propriétés optiques et/ou électroniques des diodes 2 présentent une homogénéité améliorée d'une diode à l'autre. Pour cela, le substrat 4 comporte une surface supérieure 4b formée par un matériau monocristallin ; la couche isolante inférieure 5 est en un matériau cristallin épitaxié à partir de la surface supérieure 4b du substrat 4; et les bandes conductrices de nucléation 6i sont en un matériau comportant un métal de transition épitaxié à partir du matériau cristallin de la couche isolante inférieure 5.

Ainsi, comme le montrent les figures 3A et 3B, le substrat 4 comporte un matériau de croissance monocristallin au moins au niveau de la surface supérieure 4b. Ainsi, au niveau de cette surface supérieure 4b, le matériau de croissance est formé d'un seul cristal et ne comporte donc pas plusieurs cristaux séparés les uns des autres par des joints de grain. Le matériau du substrat 4 présente des propriétés cristallographiques, en termes de paramètre de maille et de type de structure, adapté à la croissance épitaxiale d'un matériau cristallin de la couche isolante inférieure 5. Ainsi, il présente de préférence une structure cristalline de type cubique faces centrées orientée suivant la direction [111] ou une structure cristalline de type hexagonal orientée suivant la direction [0001]. De préférence également, il présente un paramètre de maille aₛ tel que le désaccord de maille m=Δa/aₛ avec le matériau de la couche isolante inférieure 5 est inférieur ou égal à 20%. De préférence, le matériau du substrat 4 est du silicium monocristallin, de structure cristalline de type cubique faces centrées dont le plan de croissance est orienté suivant la direction [111], et dont le paramètre de maille aₛ est de 3,84Â environ.

La couche isolante inférieure 5 est en un matériau cristallin épitaxié à partir de la surface supérieure 4b du substrat 4. Ainsi, le matériau de la couche isolante inférieure 5 comporte un réseau cristallin en relation d'épitaxie avec celui du matériau monocristallin du substrat. Le réseau cristallin du matériau de la couche isolante inférieure 5 présente une maille élémentaire définie notamment par ses axes cristallographiques notés ici, à titre purement illustratif, aᵢ, bᵢ, cᵢ. Le réseau cristallin présente donc un alignement d'au moins un axe cristallographique aᵢ, bᵢ orienté dans le plan du matériau et d'au moins un axe cristallographique cᵢ orienté de manière orthogonale au plan du matériau, avec les axes cristallographiques aₛ, bₛ et cₛ du matériau monocristallin du substrat, respectivement. Cela se traduit par le fait que l'axe cristallographique aᵢ est sensiblement parallèle, en tout point de la surface supérieure 5b, à l'axe cristallographique aₛ, tout comme, respectivement, les axes cristallographiques bᵢ et cᵢ relativement aux axes cristallographiques bₛ et cₛ. De plus, que le matériau de la couche isolante inférieure 5 soit monocristallin ou polycristallin, du fait de sa relation d'épitaxie avec le matériau monocristallin du substrat, chaque axe cristallographique aᵢ, bᵢ, cᵢ est sensiblement identique en tout point de la surface supérieure 5b. En d'autres termes, les axes cristallographiques aᵢ sont sensiblement identiques, c'est-à-dire parallèles entre eux, en tout point de la surface supérieure 5b, tout comme, respectivement, les axes cristallographiques bᵢ et cᵢ. Un matériau polycristallin est formé, à la différence d'un matériau monocristallin, de plusieurs cristaux séparés les uns des autres par des joints de grains.

Le matériau de la couche isolante inférieure 5 présente des propriétés cristallographiques, en termes de paramètre de maille et de type de structure cristalline, telles qu'il est adapté à être épitaxié à partir du matériau monocristallin du substrat 4. Il est de plus adapté à permettre la croissance épitaxiale des bandes conductrices de nucléation 6ᵢ en un matériau comportant un métal de transition à partir de la surface supérieure 5b. Il présente, de préférence, un paramètre de maille tel que le désaccord de maille avec le matériau monocristallin du substrat 4 est inférieur ou égal à 20%. De plus, le type de la structure cristalline est tel que ses axes cristallographiques aᵢ, bᵢ, cᵢ peuvent être respectivement parallèles aux axes aₛ, bₛ, cₛ du matériau monocristallin du substrat. La structure cristalline peut être de type cubique faces centrées, orientée suivant la direction [111], ou de type hexagonal orientée suivant la direction [0001], voire de type orthorhombique orientée suivant la direction [111]. De préférence, le matériau de la couche isolante inférieure 5 est du nitrure d'aluminium AlN, de paramètre de maille 3,11Å environ, et de structure cristalline de type hexagonal dont le plan de croissance est orienté suivant la direction [0001].

Les bandes conductrices de nucléation 6ᵢ sont en un matériau comportant un métal de transition épitaxié à partir de la surface supérieure 5b de la couche isolante inférieure 5. Le matériau de nucléation comporte un réseau cristallin en relation d'épitaxie avec celui du matériau de la couche isolante inférieure 5. Le réseau cristallin du matériau de nucléation présente une maille élémentaire définie notamment par ses axes cristallographiques notés ici, à titre purement illustratif, aₙ, bₙ, cₙ. Le réseau cristallin présente donc un alignement d'au moins un axe cristallographique aₙ, bₙ orienté dans le plan du matériau et d'au moins un axe cristallographique cₙ orienté de manière orthogonale au plan du matériau, avec les axes cristallographiques aᵢ, bᵢ, et cᵢ, du matériau de la couche isolante inférieure 5, respectivement, au niveau de la surface supérieure 5b. Cela se traduit par le fait que l'axe cristallographique aₙ est sensiblement parallèle, en tout point de la surface de nucléation 6b, à l'axe cristallographique aᵢ de la surface supérieure 5b, tout comme les axes cristallographiques bₙ et cₙ relativement aux axes cristallographiques bᵢ et cᵢ. De plus, que le matériau de nucléation soit monocristallin ou polycristallin, chaque axe cristallographique aₙ, bₙ, cₙ est identique en tout point de la surface de nucléation 6b. En d'autres termes, les axes cristallographiques aₙ sont identiques, c'est-à-dire parallèles entre eux, en tout point de la surface de nucléation 6b, tout comme, respectivement, les axes cristallographiques bₙ et cₙ.

Le matériau de nucléation présente des propriétés cristallographiques, en termes de paramètre de maille et de type de structure, telles qu'il peut être épitaxié à partir du matériau de la couche isolante inférieure 5. Il est de plus adapté à la croissance épitaxiale, à partir de la surface de nucléation 6b, d'un fil 9. De préférence, il présente ainsi un paramètre de maille tel que le désaccord de maille avec le matériau de la couche isolante inférieure 5 est inférieur ou égal à 20%. De plus, le type de la structure cristalline est tel que ses axes cristallographiques aₙ, bₙ, cₙ peuvent être respectivement parallèles aux axes aᵢ, bᵢ, cᵢ du matériau de la couche isolante inférieure 5. La structure cristalline peut être de type cubique faces centrées, orientée suivant la direction [111] ou de type hexagonal orientée suivant la direction [0001], voire de type orthorhombique orientée suivant la direction [111]. Le matériau de nucléation comporte un métal de transition, c'est-à-dire qu'il peut être en un métal de transition ou en un composé comportant un métal de transition, par exemple un nitrure ou un carbure d'un métal de transition. Les métaux de transition, ainsi que leurs nitrures et carbures, présentent notamment l'avantage d'une bonne conductivité électrique, proche de celle des métaux. Le matériau de nucléation peut être choisi parmi le titane Ti, le zirconium Zr, le hafnium Hf, le vanadium V, le niobium Nb, le tantale Ta, le chrome Cr, le molybdène Mo et le tungstène W, un nitrure de ces éléments TiN, ZrN, HfN, VN, NbN, TaN, CrN, MoN, ou WN, ou un carbure de ces éléments TiC, ZrC, HfC, VC, NbC, TaC, CrC, MoC, WC. Les nitrures et carbures de métal de transition peuvent comporter une proportion atomique en métal de transition différente de 50%. De préférence, le matériau de nucléation est choisi parmi un nitrure de titane TiN, de zirconium ZrN, de hafnium HfN, de vanadium VN, de niobium NbN, de tantale TaN, de chrome CrN, de molybdène MoN ou de tungstène WN, ou un carbure de titane TiN, de zirconium ZrN, de hafnium HfN, de vanadium VN, de niobium NbN, ou de tantale TaN. De préférence, le matériau de nucléation est choisi parmi un nitrure ou un carbure de titane TiN, TiC, de zirconium ZrN, ZrC, de hafnium HfN, HfC, de vanadium VN, VC, de niobium NbN, NbC, ou de tantale TaN, TaC. De préférence, le matériau de nucléation est choisi parmi un nitrure de titane TiN, de zirconium ZrN, de hafnium HfN, de niobium NbN, ou de tantale TaN. De préférence, le matériau de nucléation est choisi parmi un nitrure de hafnium HfN ou de niobium NbN.

Les premières portions dopées 9 des diodes 2 sont épitaxiées à partir des surfaces de nucléation 6b des différentes bandes conductrices de nucléation 6ᵢ. Le matériau du fil comporte un réseau cristallin en relation d'épitaxie avec celui du matériau de nucléation. Le réseau cristallin du matériau du fil présente une maille élémentaire définie notamment par ses axes cristallographiques notés ici, à titre purement illustratif, a_{f}, b_{f}, c_{f}. Les axes cristallographiques a_{f}, b_{f}, c_{f} du matériau du fil sont respectivement sensiblement parallèles aux axes cristallographiques aₙ, bₙ, cₙ du matériau de nucléation au niveau de la surface de nucléation 6b. En d'autres termes, l'axe cristallographique a_{f} est parallèle à l'axe cristallographique aₙ de la surface de nucléation 6b. Il en est de même pour les axes cristallographiques b_{f} et c_{f} relativement aux axes cristallographiques bₙ et cₙ. De plus, dans la mesure où les axes cristallographiques aₙ, bₙ, cₙ sont respectivement identiques d'une surface de nucléation 6bᵢ à l'autre, chaque axe cristallographique a_{f}, b_{f}, c_{f} est identique d'un fil 9 à l'autre. En d'autres termes, les axes cristallographiques a_{f} sont identiques, c'est-à-dire parallèles entre eux, d'un fil à l'autre. Il en est de même pour les axes cristallographiques bₙ et cₙ. Ainsi, les fils présentent des propriétés cristallographiques, en termes d'orientation et de position du réseau cristallin, sensiblement identiques. Le dispositif optoélectronique 1 présente ainsi des propriétés cristallographiques sensiblement homogènes au niveau des fils, ce qui contribue à homogénéiser les propriétés électriques et/ou optiques des diodes électroluminescentes 2.

Les inventeurs ont ainsi mis en évidence que, de manière surprenante, les portions de nucléation en nitrure de métal de transition sont épitaxiées et non pas seulement texturées lorsqu'elles sont déposées sur une couche isolante inférieure 5 épitaxiée, et non pas directement à partir de la surface supérieure 4b du matériau monocristallin du substrat.

Par épitaxie, on entend que le matériau cristallin épitaxié comporte un réseau cristallin, ou structure cristalline, en relation d'épitaxie avec celui du matériau de nucléation à partir duquel il est épitaxié. Par relation d'épitaxie, on entend que le matériau épitaxié présente un alignement des orientations cristallographiques de son réseau cristallin, dans au moins une direction dans le plan du matériau et au moins une direction orthogonale au plan du matériau, avec celles du réseau cristallin du matériau de nucléation. Le plan du matériau épitaxié est ici un plan de croissance du matériau, parallèle à la surface de nucléation. L'alignement est réalisé de préférence à 30° près, voire à 10° près. Cela se traduit par le fait qu'il y a accord total d'orientation et de position cristallographique entre le réseau cristallin du matériau épitaxié et celui du matériau de nucléation. De préférence, le matériau cristallin épitaxié présente un paramètre de maille a₂, mesuré dans le plan de croissance, tel que le désaccord de maille m=(a2-a1)/a1=Δa/a₁ avec le matériau de nucléation, de paramètre de maille est inférieur ou égal à 20%. Ainsi, lorsqu'un matériau cristallin est épitaxié à partir d'un matériau cristallin de nucléation, c'est-à-dire formé par croissance épitaxiale, la relation d'épitaxie entre ces deux matériaux cristallins se traduit par le fait qu'au moins un axe cristallographique du réseau cristallin du matériau épitaxié, orienté dans le plan du matériau épitaxié, par exemple aₑ et/ou bₑ, et au moins un axe cristallographique, orienté de manière orthogonale au plan, par exemple cₑ, sont respectivement sensiblement parallèles aux axes cristallographiques aₙ et/ou bₙ, et cₙ du réseau cristallin du matériau de nucléation.

Un matériau épitaxié est un cas particulier des matériaux dits texturés dans le sens où les matériaux texturés présentent une direction cristallographique préférentielle orientée de manière orthogonale au plan du matériau, mais ne présentent pas de direction cristallographique préférentielle orientée dans le plan du matériau. Par ailleurs, la direction cristallographique préférentielle orthogonale au plan du matériau texturé n'est pas, ou peu, dépendante des propriétés cristallines du matériau de nucléation. Ainsi, un matériau texturé présente une seule direction cristallographique privilégiée, par exemple celle de l'axe c et non pas trois directions privilégiées. Le réseau du matériau texturé présente alors une structure polycristalline dont les différents domaines cristallins, séparés par des joints de grains, sont tous orientés suivant le même axe cristallographique c privilégié. En revanche, ils ne présentent pas de relations de parallélisme entre eux dans le plan de croissance. Autrement dit, les axes c des domaines cristallins sont parallèles entre eux mais les axes a, comme les axes b, ne sont pas parallèles entre eux et sont orientés de manière sensiblement aléatoire. Cette direction cristallographique privilégiée n'est pas, ou est peu dépendante des propriétés cristallines du matériau de nucléation. Ainsi, il est possible d'obtenir un matériau texturé à partir d'un matériau de nucléation présentant une structure monocristalline, polycristalline, voire amorphe.

Ainsi, comme le montre la figure 3C, les fils 9, ici en GaN épitaxié par MOCVD, lorsqu'ils sont épitaxiés à partir d'un matériau de nucléation texturé et non pas épitaxié, présentent tous une même direction de croissance, celle-ci étant sensiblement parallèle à l'axe cristallographique cₙ. En revanche, il apparaît que la forme hexagonale des fils 9 n'est pas orientée de manière identique d'un fil à l'autre, ce qui traduit le fait que les axes cristallographiques a_{f} et b_{f} ne sont respectivement pas orientés de manière identique d'un fil à l'autre. Les fils 9 présentent alors des propriétés cristallographiques différentes d'un fil à l'autre, ce qui peut se traduire par une certaine inhomogénéité dans les propriétés électriques et/ou optiques des diodes électroluminescentes 2.

En revanche, comme le montre la figure 3D, les fils 9, ici en GaN épitaxié par MOCVD, lorsqu'ils sont épitaxiés à partir d'un matériau de nucléation épitaxié et non pas texturé, présentent tous une même direction de croissance, celle-ci étant sensiblement parallèle à l'axe cristallographique cₙ. De plus, il apparaît que la forme hexagonale des fils 9 est ici orientée de manière identique pour tous les fils 9, ce qui traduit le fait que les axes cristallographiques a_{f} et b_{f} sont respectivement orientés de manière identique d'un fil à l'autre. Ainsi, les fils 9 présentent des propriétés cristallographiques, en termes d'orientation et de position du réseau cristallin, sensiblement identiques. Le dispositif optoélectronique 1 présente ainsi des propriétés cristallographiques sensiblement homogènes au niveau des fils 9, ce qui contribue à homogénéiser les propriétés électriques et/ou optiques des diodes électroluminescentes 2.

Les figures 4A à 4I illustrent schématiquement et de manière partielle, en coupe transversale, différentes étapes d'un exemple de procédé de réalisation du dispositif optoélectronique 1 selon le mode de réalisation préféré décrit précédemment. Chaque figure illustre une vue en coupe selon le plan AA (gauche) et une vue en coupe selon le plan BB (droite).

En référence à la figure 4A, on fournit le substrat 4 dont le matériau est monocristallin au moins au niveau de la surface supérieure. Dans cet exemple, le substrat 4 est en silicium dont la structure est de type cubique faces centrées orientée suivant la direction [111]. Son paramètre de maille dans le plan de la surface supérieure est de l'ordre de 3,84Â.

Puis, on dépose la couche isolante inférieure 5, de manière à recouvrir la surface supérieure du substrat, par un procédé du type dépôt chimique en phase vapeur (CVD, pour Chemical Vapor Déposition, en anglais), par exemple aux précurseurs organométalliques (MOCVD, pour Metal-Organic Chemical Vapor Déposition, en anglais) ou par un procédé de type épitaxie par jets moléculaires (MBE, pour Molecular-Beam Epitaxy, en anglais), du type épitaxie en phase vapeur aux hydrures (HVPE, pour Hybrid Vapor Phase Epitaxy, en anglais), du type épitaxie par couche atomique (ALE, pour Atomic Layer Epitaxy, en anglais) ou dépôt par couche atomique (ALD, pour Atomic Layer Déposition, en anglais), voire par évaporation ou par pulvérisation cathodique (sputtering, en anglais).

Dans cet exemple, le matériau de la couche isolante inférieure 5 est du nitrure d'aluminium épitaxié, dont la structure cristalline est de type hexagonal et est orientée suivant la direction [0001]. Son paramètre de maille dans le plan (X,Y) est de l'ordre de 3,11Â. Il est déposé par MOCVD. Le rapport V/III nominal, défini comme le rapport entre le flux molaire d'éléments de la colonne V sur le flux molaire d'éléments de la colonne III, c'est-à-dire ici le rapport N/AI, est compris entre 200 et 1000. La pression est de l'ordre de 75 torrs. La température de croissance T, mesurée au niveau du substrat, peut être dans un premier temps supérieure ou égale à 750°C pour la phase de nucléation, puis dans un second temps de l'ordre de 950°C pour la phase de croissance.

En référence à la figure 4B, on forme les bandes conductrices de nucléation 6i sur la surface supérieure de la couche isolante inférieure 5. Pour cela, on réalise la croissance épitaxiale d'une couche d'un matériau de nucléation en un matériau comportant un métal de transition, par exemple par une technique de pulvérisation cathodique, dont la température de croissance est avantageusement comprise entre la température ambiante, par exemple 20°C, et 1000°C. De manière surprenante, les bandes de nucléation sont également épitaxiées lorsqu'elles sont déposées par pulvérisation cathodique avec une température de croissance comprise entre la température ambiante, par exemple 20°C, et 500°C, par exemple une température sensiblement égale à 400°C. La puissance peut être de l'ordre de 400W. La pression peut être de l'ordre de 8.10⁻³ torr. Les techniques de pulvérisation cathodique à haute température et de dépôt chimique en phase vapeur peuvent également être utilisées. On réalise ensuite, par des techniques de photolithographie et de gravure classiques, la gravure de la couche continue du matériau de nucléation pour former une pluralité de bandes conductrices de nucléation 6i distinctes les unes des autres.

De manière avantageuse, dans le cas où les bandes conductrices de nucléation 6ᵢ sont réalisées en un matériau polycristallin, une étape de recuit de cristallisation peut être effectuée de manière à obtenir un matériau de nucléation monocristallin. Le recuit peut être effectué à une température de recuit correspondant sensiblement à la température de cristallisation du matériau de nucléation, à savoir 1620°C dans le cas ici du nitrure de métal de transition. Cependant, de manière surprenante, la cristallisation du matériau de nucléation peut également être obtenue à une température de recuit inférieure à la température de cristallisation, par exemple dans une gamme de température allant de 600°C à 1620°C, de préférence comprise entre 800°C et 1200°C, par exemple égale à 1000°C environ. Le recuit peut être effectué pendant une durée par exemple supérieure à 1min, de préférence supérieure à 5min, voire à 10min, par exemple 20min. Il peut être effectué sous un flux d'azote (N2) et d'ammoniac (NH3). La pression peut être de l'ordre de 75 torrs.

En référence à la figure 4C, on dépose ensuite la couche isolante intermédiaire 7 formant un masque de croissance et on réalise les ouvertures traversantes 8. On dépose ainsi une couche d'un matériau diélectrique de manière à recouvrir les bandes conductrices de nucléation 6i et la couche isolante inférieure 5, puis on forme des ouvertures traversantes 8 de manière à déboucher localement sur les surfaces de nucléation. Le matériau diélectrique est, par exemple, un oxyde de silicium (par exemple SiO2) ou un nitrure de silicium (par exemple Si3N4), voire un empilement de plusieurs matériaux diélectriques différents. Il est gravé de manière sélective par rapport au matériau des bandes conductrices de nucléation 6i. De préférence, les dimensions latérales des ouvertures sont inférieures à la largeur des bandes conductrices de nucléation 6i, par exemple au moins deux fois inférieures.

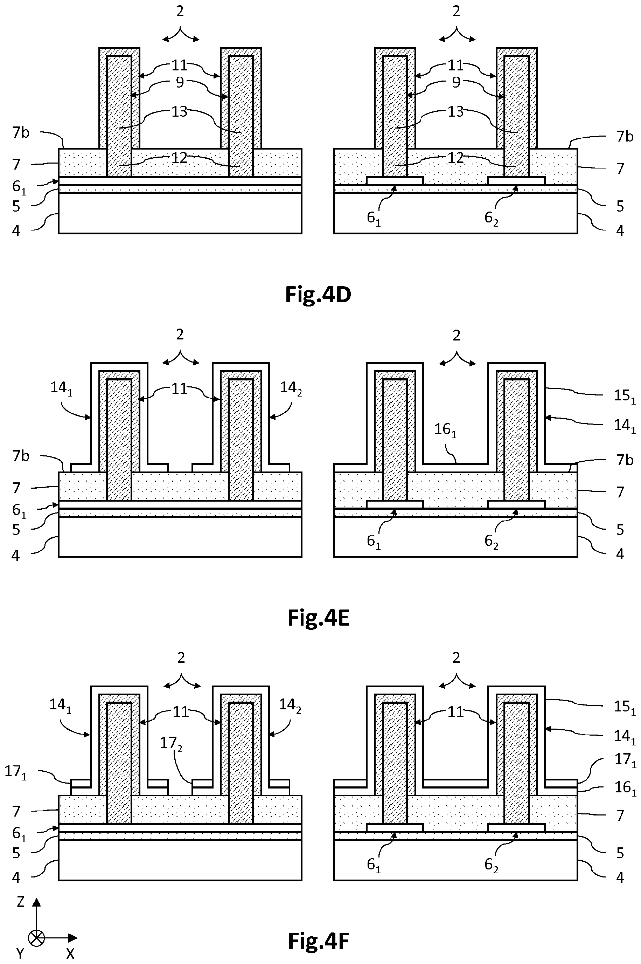

En référence à la figure 4D, on forme les fils 9, ici en GaN, par croissance épitaxiale à partir des surfaces de nucléation des différentes bandes conductrices de nucléation 6ᵢ, au travers des ouvertures de la couche isolante intermédiaire 7, par exemple selon un procédé identique ou similaire à celui décrit dans le document WO2012/136665. La température de croissance est portée à une première valeur T₁, par exemple comprise entre 950°C et 1100°C, et notamment comprise entre 990°C et 1060°C. Le rapport V/III nominal, ici le rapport N/Ga, présente une première valeur (V/III)₁ comprise entre 10 et 100 environ, par exemple sensiblement égale à 30. Les éléments du groupe III et du groupe V sont issus de précurseurs injectés dans le réacteur d'épitaxie, par exemple le triméthylgallium (TMGa) ou le triéthylgallium (TEGa) pour le gallium, et l'ammoniac (NH₃) pour l'azote. Le rapport H_{2/}N₂ présente une première valeur (H_{2/}N₂)₁ supérieure ou égale à 60/40, de préférence supérieure ou égale à 70/30, voire davantage, par exemple sensiblement égale à 90/10. La pression peut être fixée à 100mbar environ. On obtient ainsi des premières portions dopées 9 sous forme de fils qui s'étendent suivant l'axe longitudinal Δ à partir des surfaces de nucléation. Le premier composé semiconducteur des premières portions dopées 9, à savoir ici le GaN, est dopé de type n par du silicium. La partie inférieure 12 des fils 9 est située dans les ouvertures de la couche isolante intermédiaire 7, et se prolonge suivant l'axe longitudinal Δ par la partie supérieure 13. On obtient ici une pluralité de fils 9 épitaxiés à partir des surfaces de nucléation, dont les propriétés cristallographiques sont sensiblement identiques, dans la mesure où la nucléation des fils 9 a été effectuée à partir de surfaces de nucléation qui présentent sensiblement les mêmes propriétés cristallographiques.

On forme les zones actives par croissance épitaxiale à partir de la surface exposée des fils 9, c'est-à-dire ici sur la partie supérieure 13 des fils 9. Plus précisément, on forme un empilement de couches barrières et d'au moins une couche formant un puits quantique, lesdites couches étant alternées dans le sens de la croissance épitaxiale. Les couches formant les puits quantiques et les couches barrières peuvent être réalisées en InGaN, avec des proportions atomiques différentes pour les couches de puits quantiques et les couches barrières. A titre d'exemple, les couches barrières sont réalisées en InₓGa₍₁₋ₓ₎N avec x égal à 18% atomique environ, et les couches de puits quantiques sont également réalisées en In_{y}Ga_{(1-y)}N, avec y supérieur à x, par exemple de l'ordre de 25% atomique, de manière à améliorer le confinement quantique des porteurs de charge dans les puits quantiques. La formation des couches barrières et des couches de puits quantiques peut être réalisée à une valeur T₃ de température de croissance sensiblement égale à la valeur T₂, à savoir ici 750°C. Le rapport V/III présente une valeur (V/III)₃ sensiblement égale à la valeur (V/III)₂. Le rapport H_{2/}N₂ présente une valeur sensiblement égale à la valeur (H₂/N₂)₂ lors de la formation des couches barrières et présente une valeur sensiblement inférieure à la valeur (H₂/N₂)₂ lors de la formation des couches de puits quantiques, par exemple 1/99. La pression peut rester inchangée. On obtient ainsi des couches barrières en InGaN avec 18% atomique environ d'indium et des couches de puits quantiques en InGaN avec 25% atomique environ d'indium.

On forme ensuite les secondes portions dopée p par croissance épitaxiale de manière à recouvrir et entourer au moins en partie les zones actives. Pour cela, la température de croissance peut être portée à une quatrième valeur T₄ supérieure à la valeur T₃, par exemple de l'ordre de 885°C. Le rapport V/III peut être porté à une quatrième valeur (V/III)₄ supérieure à la valeur (V/III)₃, par exemple de l'ordre de 4000. Le rapport H_{2/}N₂ est porté à une quatrième valeur (H₂/N₂)₄ supérieure à la valeur (H₂/N₂)₂, par exemple de l'ordre de 15/85. Enfin, la pression peut être diminuée à une valeur de l'ordre de 300mbar. On obtient ainsi des secondes portions 11 dopées p, par exemple en GaN ou InGaN dopé de type p, qui recouvrent et entourent ici continûment les zones actives. Les secondes portions 11 dopées p et les zones actives forment ainsi les coquilles des diodes 2 en configuration cœur/coquille. Dans cet exemple, la zone active et la seconde portion dopée 11 des diodes 2 recouvrent la partie supérieure 13 de chaque fil, à partir de la surface supérieure de la couche isolante intermédiaire 7.

En référence à la figure 4E, on forme les bandes conductrices supérieures 14ⱼ distinctes les unes des autres, qui s'étendent sur la surface supérieure de la couche isolante intermédiaire 7 et viennent au contact des secondes portions dopées 11 de diodes. Pour cela, on dépose de manière conforme une couche continue d'un matériau conducteur et ici partiellement transparent au rayonnement lumineux émis par les diodes. Puis, par photolithographie et gravure, on forme les bandes conductrices supérieures 14ⱼ, distinctes les unes des autres. Elles comportent ici chacune des parties qui recouvrent les secondes portions dopées 11 d'un ensemble Dⱼ de diodes, ces parties recouvrantes 15ⱼ étant reliées deux à deux par des parties de liaison 16ⱼ qui s'étendent sur la surface supérieure de la couche isolante intermédiaire 7.

En référence à la figure 4F, de manière avantageuse, on recouvre les parties de liaison 16ⱼ des bandes conductrices supérieures 14ⱼ par une couche métallique 17 adaptée à réduire la résistance électrique des bandes conductrices supérieures 14ⱼ et améliorer ainsi la circulation du courant électrique. Cette couche métallique 17 est déposée sur les bandes conductrices supérieures 14ⱼ puis est gravée pour ne recouvrir que les parties de liaison 16ⱼ et non pas les parties recouvrantes 15ⱼ. Cette couche métallique 17 peut être en un ou plusieurs matériaux choisis parmi l'aluminium, l'argent, l'or ou tout autre matériau adapté, et présente une épaisseur par exemple comprise entre 5nm et 200nm, de préférence comprise entre 10nm et 100nm, par exemple égale à 30nm environ. En variante, la couche métallique 17 peut être déposée préalablement au dépôt des bandes conductrices supérieures 14ⱼ. Elle est gravée de manière à ne pas s'étendre autour des secondes portions dopées 11 suivant l'axe Z.

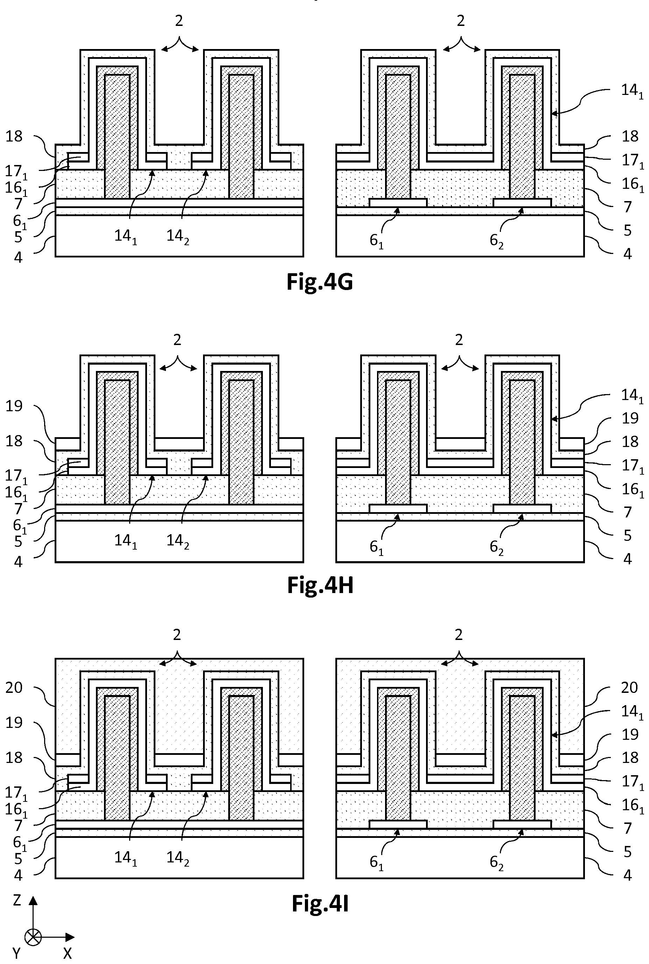

En référence à la figure 4G, de manière avantageuse, on dépose la couche isolante supérieure 18 de manière à recouvrir continument les bandes conductrices supérieures 14ⱼ, la couche métallique 17 et la couche isolante intermédiaire 7. La couche isolante supérieure 18 est en un matériau diélectrique tel que, par exemple, un oxyde de silicium (par exemple SiO2) ou un nitrure de silicium (par exemple Si3N4), voire un empilement de plusieurs matériaux diélectriques différents.

En référence à la figure 4H, de manière avantageuse, on dépose ensuite une couche réflectrice 19 de manière à recouvrir la surface de la couche isolante supérieure 18 sans recouvrir les fils 9. La couche réflectrice 19 s'étend ainsi essentiellement dans le plan (X,Y). Cette couche réflectrice 19 peut être en un ou plusieurs matériaux choisis parmi l'aluminium, l'argent, l'or ou tout autre matériau adapté, et présente une épaisseur par exemple comprise entre 20nm et 1500nm, de préférence comprise entre 400nm et 800nm. L'épaisseur de la couche réflectrice 19 est choisie de sorte que le rayonnement lumineux incident émis par les diodes 2 soit réfléchi suivant la direction +Z.

En référence à la figure 4I, on dépose une couche d'encapsulation 20 de manière à recouvrir entièrement les diodes. La couche d'encapsulation 20 est réalisée en un matériau diélectrique transparent au rayonnement lumineux émis par les diodes 2, tel que, par exemple, un oxyde de silicium (par exemple SiO2) ou un nitrure de silicium (par exemple Si3N4), voire un empilement de plusieurs matériaux diélectriques différents. L'épaisseur de la couche d'encapsulation 20 est par exemple comprise entre 250nm et 50µm.

On procède ensuite à la réalisation des premiers plots 21ᵢ et des seconds plots 25ⱼ de connexion. Dans le cas où ces plots sont réalisés en face arrière 3a du support, on effectue un amincissement du substrat 4, puis on réalise les premiers orifices traversants 22ᵢ débouchant au niveau des bandes conductrices de nucléation 6ᵢ ainsi que les seconds orifices traversants 26ⱼ débouchant au niveau des bandes conductrices supérieures 14ⱼ. Les flancs des orifices traversants peuvent être revêtus d'une couche isolante 24, puis un matériau conducteur 23 remplit l'intérieur des orifices traversants. Les premiers et seconds plots de connexion 21ᵢ et 25ⱼ sont ensuite formés, respectivement, au niveau de chaque premier et second orifice traversant 22ᵢ et 26ⱼ. Une hybridation du support à un circuit intégré de commande est ensuite effectuée par collage moléculaire, par câblage par fil, ou par connexion au moyen d'éléments conducteurs et fusibles.

Le procédé de réalisation du dispositif optoélectronique 1 présente l'avantage de ne pas avoir à réaliser une individualisation électrique des diodes 2 par le moyen de tranchées isolantes formées entre les diodes 2 à partir de la face avant 3b du support. Les diodes 2 sont ici individualisées par les premières et secondes électrodes qui se présentent sous la forme de bandes conductrices distinctes les unes des autres. Ainsi, le support présente une tenue mécanique améliorée, ce qui facilite notamment l'hybridation au circuit de commande. De plus, les diodes 2 présentent des propriétés optiques et/ou électroniques préservées dans la mesure où l'individualisation des diodes 2 ne requiert pas, comme dans l'exemple de l'art antérieur mentionné précédemment, une gravure des portions dopées et de la zone active. L'homogénéité des propriétés optiques et/ou électroniques des diodes 2 est en outre améliorée lorsque les diodes 2 sont formées à partir de bandes conductrices de nucléation 6i en relation d'épitaxie avec le matériau monocristallin du substrat.

Des modes de réalisation particuliers viennent d'être décrits. Différentes variantes et modifications apparaîtront à l'homme du métier.

Ainsi, comme l'illustre la figure 5, chaque pixel Pᵢⱼ peut comporter plusieurs diodes. Ainsi, l'application d'une différence de potentiel au pixel Pᵢⱼ conduit à une activation des diodes 2 de ce pixel, les diodes 2 des autres pixels restant désactivées.

Par ailleurs, comme l'illustre la figure 6A, le dispositif optoélectronique 1 peut comporter un circuit intégré de routage 28 comportant des interconnexions électriques 29 assurant une mise en série de plusieurs pixels entre eux. Dans cet exemple, les diodes 2 du pixel P₁ sont connectées en série avec les diodes 2 du pixel P₂ au moyen des interconnexions électriques 29 du circuit de routage 28 connectés aux premiers et seconds orifices traversants 22ᵢ, 26ⱼ. Le circuit intégré de routage 28 peut être assemblé et connecté électriquement au circuit de commande (non représenté) au moyen des plots de connexion 21ᵢ, 25ⱼ. Ainsi, dans cet exemple, une différence de potentiel peut être appliquée aux pixels P1 et P2 connectés en série, par l'intermédiaire des plots de connexion 21₂ et 25₁. Le potentiel électrique du plot de connexion 25₁ est appliqué à la bande conductrice supérieure 14₁ du pixel P₁ par l'intermédiaire de l'orifice traversant 26₁ et de l'interconnexion 29.1, et le potentiel électrique du plot de connexion 21₂ est appliqué à la bande conductrice de nucléation 6₂ du pixel P₂ par l'intermédiaire de l'orifice traversant 22₂ et de l'interconnexion 29.3. Les pixels P₁ et P₂ sont connectés en série par la connexion électrique de la bande conductrice de nucléation 6₁ du pixel P₁ avec la bande conductrice supérieure 14₂ du pixel P₂ réalisée par les orifices traversants 22₁ et 26₂ et l'interconnexion 29.2. En variante, l'interconnexion 29.2 peut être omise et les orifices traversants 22₁ et 26₂ peuvent être en contact électrique directement dans le substrat 4.

Comme l'illustre la figure 6B, le dispositif optoélectronique 1 peut comporter une ou plusieurs interconnexions électriques 30 situées au niveau de la couche isolante intermédiaire 7, permettant, dans cet exemple, la mise en série des diodes 2 du pixel P₁ avec les diodes 2 du pixel P₂. L'interconnexion électrique 30 est formée ici d'un orifice traversant rempli d'un matériau conducteur débouchant d'une part sur la bande conductrice de nucléation 6₁ du pixel P₁ et d'autre part sur la bande conductrice supérieure 14₂ du pixel P₂. Dans cet exemple, un circuit de routage 28 est prévu et assure la polarisation électrique des pixels P₁ et P₂ connectés en série, au moyen des interconnexions 29.1 et 29.3.

Les exemples des figures 6A et 6B sont donnés à titre purement illustratif et d'autres configurations d'interconnexions électriques internes ou formées dans un circuit intégré de routage sont possibles de manière à assurer une connexion des pixels en série ou en parallèle. Par ailleurs, en variante et comme mentionné précédemment, les plots de connexion électrique peuvent être situés en face avant ou en face arrière du support.

Ainsi, on a décrit un dispositif optoélectronique 1 à diodes électroluminescentes 2 pouvant avantageusement former un écran d'affichage ou un projecteur d'image à haute intensité lumineuse et haute résolution spatiale. Cependant, l'invention s'applique également au domaine des photodiodes adaptées à recevoir et détecter un rayonnement lumineux et à le convertir en des signaux électriques relatifs aux différents pixels.

On a décrit des diodes 2 tridimensionnelles de type filaire, mais l'invention s'applique également aux premières portions dopées en forme de plots tridimensionnels dont la hauteur suivant l'axe Z est du même ordre de grandeur que ses dimensions transversales dans le plan (X,Y), ainsi qu'aux premières portions dopées en forme de pyramides éventuellement tronquées.

On a décrit des diodes 2 en configuration cœur/coquille où les zones actives et les secondes portions dopées recouvrent les flancs et le sommet des fils 9. L'invention s'applique également à la configuration axiale des diodes 2 où les zones actives et les secondes portions dopées ne recouvrent que le sommet des fils.

On a également décrit une orientation relative sensiblement orthogonale des bandes conductrices de nucléation vis-à-vis des bandes conductrices supérieures, mais d'autres orientations sont possibles, où les les bandes de nucléation et les bandes supérieures forment par exemple deux à deux un angle non nul inférieur ou supérieur à 90°.

## Revendications

1. Dispositif optoélectronique (1), comportant :
- un support, comportant des faces opposées dites arrière (3a) et avant (3b) ;
- une pluralité de premières bandes conductrices (6ᵢ) formant des premières électrodes de polarisation, distinctes les unes des autres et reposant sur ladite face avant (3b), réalisées en un matériau électriquement conducteur;
- une couche isolante intermédiaire (7) recouvrant les premières bandes conductrices (6ᵢ) et comportant des ouvertures traversantes (8) débouchant sur les premières bandes conductrices (6ᵢ) ;
- une pluralité de diodes (2), chacune comportant une première portion dopée (9) tridimensionnelle et une seconde portion dopée (11) agencées de manière à former une jonction p-n, les premières portions dopées (9) étant au contact des premières bandes conductrices (6ᵢ) au travers desdites ouvertures traversantes (8) et s'étendant suivant un axe longitudinal sensiblement orthogonal à la face avant (3b) ;
- une pluralité de bandes conductrices supérieures (14ⱼ) formant des secondes électrodes de polarisation, distinctes les unes des autres et reposant sur la couche isolante intermédiaire (7), chaque bande conductrice supérieure (14ⱼ) étant agencée de manière à être au contact de secondes portions dopées (11) d'un ensemble de diodes (2) dont les premières portions dopées (9) sont au contact de différentes premières bandes conductrices (6ᵢ) ;
**caractérisé en ce que** les premières bandes conductrices (6ᵢ) sont des bandes conductrices de nucléation réalisées en un matériau électriquement conducteur adapté à la croissance des premières portions (9) dopées des diodes (2).

2. Dispositif optoélectronique (1) selon la revendication 1, dans lequel le support comporte un substrat (4) électriquement isolant dont une face supérieure (4b) forme ladite face avant (3b), ou comporte une couche ou un substrat (4), semiconducteur ou électriquement conducteur, revêtu d'une couche isolante dite inférieure (5) dont une face forme ladite face avant (3b).

3. Dispositif optoélectronique (1) selon la revendication 1 ou 2, dans lequel chaque bande conductrice de nucléation (6ᵢ) s'étend longitudinalement sur la face avant (3b), et est électriquement séparée de ses voisines, transversalement, par ladite couche isolante intermédiaire (7).

4. Dispositif optoélectronique (1) selon l'une quelconque des revendications 1 à 3, dans lequel chaque bande conductrice supérieure (14ⱼ) s'étend longitudinalement sur la couche isolante intermédiaire (7), et est électriquement séparée de ses voisines, transversalement, par une couche isolante dite supérieure (18).

5. Dispositif optoélectronique (1) selon l'une quelconque des revendications 1 à 4, dans lequel les bandes conductrices supérieures (14ⱼ) sont en un matériau conducteur au moins partiellement transparent, et recouvre au moins en partie les secondes portions dopées (11).

6. Dispositif optoélectronique (1) selon la revendication 5, dans lequel chaque bande conductrice supérieure (14ⱼ) comporte des parties (15ⱼ) recouvrant les secondes portions dopées (11) d'un ensemble de diodes (2), lesdites parties recouvrantes (15ⱼ) étant reliées entre elles par des parties dites de liaison (16ⱼ) reposant sur la couche isolante intermédiaire (7).

7. Dispositif optoélectronique (1) selon la revendication 6, dans lequel les parties de liaison (16ⱼ) des bandes conductrices supérieures (14ⱼ) sont revêtues au moins en partie par une couche métallique (19).

8. Dispositif optoélectronique (1) selon l'une quelconque des revendications 1 à 7, comportant des premiers plots de connexion (21ᵢ) reposant sur ladite face arrière (3a), et électriquement connectés aux bandes conductrices de nucléation (6ᵢ) par des premiers orifices (22ᵢ) traversant le support et remplis d'un matériau conducteur, et/ou comportant des seconds plots de connexion (25ⱼ) reposant sur ladite face arrière (3a), et électriquement connectés aux bandes conductrices supérieures (14ⱼ) par des seconds orifices (26ⱼ) traversant le support et la couche isolante intermédiaire (7) et remplis d'un matériau conducteur.

9. Dispositif optoélectronique (1) selon l'une quelconque des revendications 1 à 8, comportant un circuit intégré de commande assemblé au support et électriquement connectés aux bandes conductrices de nucléation (6ᵢ) et aux bandes conductrices supérieures (14ⱼ), adapté à appliquer une différence de potentiel, séquentiellement, à différents sous-ensembles (Pᵢⱼ) de diodes (2), la ou les diodes (2) d'un même sous-ensemble (Pᵢⱼ) étant au contact d'une même bande conductrice de nucléation (6ᵢ) et d'une même bande conductrice supérieure (14ⱼ), la ou les diodes (2) de différents sous-ensembles de diodes étant au contact de différentes bandes conductrices de nucléation (6ᵢ) et/ou de différentes bandes conductrices supérieures (14ⱼ).

10. Dispositif optoélectronique (1) selon l'une quelconque des revendications 1 à 9, dans lequel au moins une diode (2jⱼ) au contact d'une première bande conductrice de nucléation (6ᵢ) et d'une première bande conductrice supérieure (14ⱼ) est connectée en série avec au moins une autre diode (2_{i'j'}), celle-ci étant au contact d'une deuxième bande conductrice de nucléation (6_{i'≠i}) distincte de la première bande de nucléation (6ᵢ) et d'une deuxième bande conductrice supérieure (14_{j'≠j}) distincte de la première bande supérieure (14ⱼ).

11. Dispositif optoélectronique (1) selon l'une quelconque des revendications 1 à 10, dans lequel le support est formé d'un substrat (4) en un matériau monocristallin formant une surface supérieure (4b), sur laquelle repose une couche isolante dite inférieure (5) en un matériau diélectrique, épitaxié à partir de la surface supérieure (4b) du substrat et formant une surface supérieure (5b) opposée, les bandes conductrices de nucléation (6ᵢ) étant en un matériau comportant un métal de transition formant un matériau cristallin de nucléation, épitaxié à partir de la surface supérieure (5b) de la couche isolante inférieure (5) et formant une surface de nucléation (6bᵢ) sur laquelle sont en contact les premières portions dopées (9) desdites diodes (2).

12. Dispositif optoélectronique (1) selon la revendication 11, dans lequel le matériau de la couche isolante inférieure (5) est choisi parmi le nitrure d'aluminium et les oxydes d'aluminium, de titane, de hafnium, de magnésium et de zirconium, et présente une structure cristalline hexagonale, cubique faces centrées ou orthorhombique.

13. Dispositif optoélectronique (1) selon la revendication 11 ou 12, dans lequel le matériau des bandes conductrices de nucléation (6ᵢ) est choisi parmi le titane, le vanadium, le chrome, le zirconium, le niobium, le molybdène, le hafnium, le tantale et le tungstène, ou parmi un nitrure ou un carbure de titane, de vanadium, de chrome, de zirconium, de niobium, de molybdène, de hafnium, de tantale et de tungstène, et présente une structure cristalline hexagonale ou cubique faces centrées, ou est un matériau à base de nitrure de gallium.

14. Dispositif optoélectronique (1) selon l'une quelconque des revendications 11 à 13, dans lequel le matériau monocristallin du substrat (4) est choisi parmi un composé III-V, un composé II-VI, ou un élément ou composé IV, et présente une structure cristalline hexagonale ou cubique faces centrées.

15. Procédé de réalisation du dispositif optoélectronique (1) selon l'une quelconque des revendications 1 à 14, comportant une étape de croissance épitaxiale des bandes conductrices de nucléation (6ᵢ) par pulvérisation cathodique à une température de croissance comprise entre la température ambiante et 500°C.

## Patentansprüche

1. Optoelektronische Vorrichtung (1), die aufweist:
- einen Träger, der gegenüberliegende so genannte Rück- (3a) und Vorderseiten (3b) aufweist;
- eine Vielzahl erster Leitungsbänder (6ᵢ), die erste Polarisationselektroden bilden, die sich voneinander unterscheiden und auf der Vorderseite (3b) ruhen, hergestellt aus einem elektrisch leitenden Material;
- eine isolierende Zwischenschicht (7), die die ersten Leitungsbänder (6ᵢ) bedeckt und Durchgangsöffnungen (8) aufweist, die auf die ersten Leitungsbänder (6ᵢ) münden;
- eine Vielzahl von Dioden (2), die je einen ersten dreidimensionalen dotierten Abschnitt (9) und einen zweiten dotierten Abschnitt (11) aufweisen, die so angeordnet sind, dass sie einen p-n-Übergang formen, wobei die ersten dotierten Abschnitte (9) durch die Durchgangsöffnungen (8) hindurch mit den ersten Leitungsbändern (6ᵢ) in Kontakt sind und sich gemäß einer Längsachse im Wesentlichen orthogonal zur Vorderseite (3b) erstrecken;
- eine Vielzahl oberer Leitungsbänder (14j), die zweite Polarisationselektroden bilden, die sich voneinander unterscheiden und auf der isolierenden Zwischenschicht (7) ruhen, wobei jedes obere Leitungsband (14ⱼ) so angeordnet ist, dass es mit zweiten dotierten Abschnitten (11) einer Einheit von Dioden (2) in Kontakt ist, deren erste dotierte Abschnitte (9) mit verschiedenen ersten Leitungsbändern (6ᵢ) in Kontakt sind; **dadurch gekennzeichnet, dass** die ersten Leitungsbänder (6ᵢ) Nukleations-Leitungsbänder sind, die aus einem elektrisch leitenden Material hergestellt sind, das für das Wachsen der ersten dotierten Abschnitte (9) der Dioden (2) geeignet ist.

2. Optoelektronische Vorrichtung (1) nach Anspruch 1, wobei der Träger ein elektrisch isolierendes Substrat (4) aufweist, von dem eine Oberseite (4b) die Vorderseite (3b) bildet, oder eine Schicht oder ein Substrat (4), halbleitend oder elektrisch leitend, aufweist, das mit einer so genannten unteren isolierenden Schicht (5) beschichtet ist, von der eine Seite die Vorderseite (3b) bildet.

3. Optoelektronische Vorrichtung (1) nach Anspruch 1 oder 2, wobei jedes Nukleations-Leitungsband (6ᵢ) sich in Längsrichtung auf der Vorderseite (3b) erstreckt und durch die isolierende Zwischenschicht (7) von seinen Nachbarn in Querrichtung elektrisch getrennt wird.

4. Optoelektronische Vorrichtung (1) nach einem der Ansprüche 1 bis 3, wobei jedes obere Leitungsband (14ⱼ) sich in Längsrichtung auf der isolierenden Zwischenschicht (7) erstreckt und durch eine so genannte obere isolierende Schicht (18) von seinen Nachbarn in Querrichtung elektrisch getrennt wird.

5. Optoelektronische Vorrichtung (1) nach einem der Ansprüche 1 bis 4, wobei die oberen Leitungsbänder (14ⱼ) aus einem zumindest teilweise transparenten leitenden Material sind und die zweiten dotierten Abschnitte (11) zumindest teilweise abdecken.

6. Optoelektronische Vorrichtung (1) nach Anspruch 5, wobei jedes obere Leitungsband (14ⱼ) Teile (15ⱼ) aufweist, die die zweiten dotierten Abschnitte (11) einer Einheit von Dioden (2) abdecken, wobei die abdeckenden Teile (15ⱼ) durch so genannte Verbindungsteile (16ⱼ) miteinander verbunden sind, die auf der isolierenden Zwischenschicht (7) ruhen.

7. Optoelektronische Vorrichtung (1) nach Anspruch 6, wobei die Verbindungsteile (16ⱼ) der oberen Leitungsbänder (14ⱼ) zumindest zum Teil mit einer Metallschicht (19) beschichtet sind.

8. Optoelektronische Vorrichtung (1) nach einem der Ansprüche 1 bis 7, die erste Anschlusskontakte (21ᵢ) aufweist, die auf der Rückseite (3a) ruhen und mit den Nukleations-Leitungsbändern (6ᵢ) durch erste Öffnungen (22ᵢ) elektrisch verbunden sind, die den Träger durchqueren und mit einem leitenden Material gefüllt sind, und/oder zweite Anschlusskontakte (25ⱼ) aufweist, die auf der Rückseite (3a) ruhen und mit den oberen Leitungsbänder (14ⱼ) durch zweite Öffnungen (26ⱼ) elektrisch verbunden sind, die den Träger und die isolierende Zwischenschicht (7) durchqueren und mit einem leitenden Material gefüllt sind.

9. Optoelektronische Vorrichtung (1) nach einem der Ansprüche 1 bis 8, die einen integrierten Steuerschaltkreis aufweist, der mit dem Träger zusammengebaut und mit den Nukleations-Leitungsbändern (6ᵢ) und den oberen Leitungsbändern (14ⱼ) elektrisch verbunden ist, geeignet, um sequentiell eine Potentialdifferenz an verschiedene Teileinheiten (Pᵢⱼ) von Dioden (2) anzuwenden, wobei die Diode oder die Dioden (2) einer gleichen Teileinheit (Pᵢⱼ) mit einem gleichen Nukleations-Leitungsband (6ᵢ) und einem gleichen oberen Leitungsband (14ⱼ) in Kontakt ist(sind), wobei die Diode oder die Dioden (2) verschiedener Teileinheiten mit verschiedenen Nukleations-Leitungsbändern (6ᵢ) und/oder verschiedenen oberen Leitungsbändern (14ⱼ) in Kontakt sind.

10. Optoelektronische Vorrichtung (1) nach einem der Ansprüche 1 bis 9, wobei mindestens eine Diode (2ᵢⱼ) in Kontakt mit einem ersten Nukleations-Leitungsband (6ᵢ) und einem ersten oberen Leitungsband (14ⱼ) mit mindestens einer weiteren Diode (2_{i'j'}) in Reihe geschaltet ist, wobei diese mit einem zweiten Nukleations-Leitungsband (6_{i'≠i}) anders als das erste Nukleationsband (6ᵢ) und einem zweiten oberen Leitungsband (14_{j'≠j}) anders als das erste obere Band (14ⱼ) in Kontakt ist.

11. Optoelektronische Vorrichtung (1) nach einem der Ansprüche 1 bis 10, wobei der Träger von einem Substrat (4) aus einem monokristallinen Material gebildet wird, das eine Oberfläche (4b) bildet, auf der eine so genannte untere isolierende Schicht (5) aus einem dielektrischen Material ruht, epitaxiert ausgehend von der Oberfläche (4b) des Substrats und eine gegenüberliegende Oberfläche (5b) bildend, wobei die Nukleations-Leitungsbänder (6ᵢ) aus einem Material sind, das ein Übergangsmetall aufweist, das ein kristallines Nukleationsmaterial bildet, epitaxiert ausgehend von der Oberfläche (5b) der unteren isolierenden Schicht (5) und eine Nukleationsfläche (6bᵢ) bildend, auf der die ersten dotierten Abschnitte (9) der Dioden (2) in Kontakt sind.

12. Optoelektronische Vorrichtung (1) nach Anspruch 11, wobei das Material der unteren isolierenden Schicht (5) ausgewählt wird aus Aluminiumnitrid und den Aluminium-, Titan-, Hafnium-, Magnesium- und Zirkonoxiden, und eine hexagonale, kubisch-flächenzentrierte oder orthorhombische Kristallstruktur aufweist.

13. Optoelektronische Vorrichtung (1) nach Anspruch 11 oder 12, wobei das Material der Nukleations-Leitungsbänder (6ᵢ) ausgewählt wird aus Titan, Vanadium, Chrom, Zirkon, Niob, Molybdän, Hafnium, Tantal und Wolfram, oder aus einem Nitrid oder Karbid von Titan, Vanadium, Chrom, Zirkon, Niob, Molybdän, Hafnium, Tantal und Wolfram, und eine hexagonale oder kubisch-flächenzentrierte Kristallstruktur aufweist, oder ein Material auf der Basis von Galliumnitrid ist.

14. Optoelektronische Vorrichtung (1) nach einem der Ansprüche 11 bis 13, wobei das monokristalline Material des Substrats (4) ausgewählt wird aus einer III-V-Verbindung, einer II-VI-Verbindung, oder einem IV-Element oder einer IV-Verbindung, und eine hexagonale oder kubisch-flächenzentrierte Kristallstruktur aufweist.

15. Verfahren zur Herstellung der optoelektronischen Vorrichtung (1) nach einem der Ansprüche 1 bis 14, das einen Schritt des epitaxialen Wachstums der Nukleations-Leitungsbänder (6) durch Kathodenzerstäubung bei einer Wachstumstemperatur zwischen der Umgebungstemperatur und 500°C aufweist.

## Claims

1. Optoelectronic device (1), comprising:
- a support that has a rear surface (3a) and a front surface (3b) opposite each other;
- a plurality of first conductive strips (6ᵢ) that form first polarization electrodes, distinct from each other and resting on said front surface (3b), made of an electrically conductive material;
- an intermediate insulating layer (7) that covers the first conductive strips (6ᵢ) and comprises through-openings (8) opening onto the first conductive strips (6ᵢ);
- a plurality of diodes (2), each of which has a first three-dimensional doped region (9) and a second doped region (11) disposed in such a way as to form a p-n junction, the first doped regions (9) being in contact with the first conductive strips (6ᵢ) through said through-openings (8) and extending along a longitudinal axis substantially orthogonal to the front surface (3b);
- a plurality of top conductive strips (14ⱼ) that form second polarization electrodes, distinct from each other and resting on the intermediate insulating layer (7), each top conductive strip (14ⱼ) being disposed in such a way as to be in contact with second doped regions (11) of a set of diodes (2) of which the first doped regions (9) are in contact with different first conductive strips (6ᵢ);
**characterized in that** the first conductive strips (6ᵢ) are nucleation conductive strips made of an electrically conductive material suitable for the growth of the first doped regions (9) of the diodes (2).

2. Optoelectronic device (1) according to Claim 1, wherein the support comprises an electrically insulating substrate (4) of which a top surface (4b) forms said front surface (3b), or comprises a semiconductor or electrically conductive layer or substrate (4) coated with a so-called bottom insulating layer (5), one surface of which forms said front surface (3b).

3. Optoelectronic device (1) according to Claim 1 or 2, wherein each nucleation conductive strip (6ᵢ) extends longitudinally on the front surface (3b) and is electrically separated from its neighbors, transversely, by said intermediate insulating layer (7).

4. Optoelectronic device (1) according to any one of Claims 1 to 3, wherein each top conductive strip (14ⱼ) extends longitudinally on the intermediate insulating layer (7), and is electrically separated from its neighbors, transversely, by a so-called top insulating layer (18).

5. Optoelectronic device (1) according to any one of Claims 1 to 4, wherein the top conductive strips (14ⱼ) are made of an at least partially transparent conductive material and at least partially cover the second doped regions (11).

6. Optoelectronic device (1) according to Claim 5, wherein each top conductive strip (14ⱼ) comprises portions (15ⱼ) that cover the second doped regions (11) of a set of diodes (2), said covering portions (15ⱼ) being connected to each other by so-called connecting parts (16ⱼ) resting on the intermediate insulating layer (7).

7. Optoelectronic device (1) according to Claim 6, wherein the connecting parts (16ⱼ) of the top conductive strips (14ⱼ) are at least partially coated with a metal layer (19).

8. Optoelectronic device (1) according to any one of Claims 1 to 7, comprising first connection pads (21ᵢ) resting on said rear surface (3a) and electrically connected to the nucleation conductive strips (6ᵢ) by first openings (22ᵢ) passing through the support and filled with a conductive material, and/or comprising second connection pads (25ⱼ) resting on said rear surface (3a) and electrically connected to the top conductive strips (14ⱼ) by second openings (26ⱼ) passing through the support and the intermediate insulating layer (7) and filled with a conductive material.

9. Optoelectronic device (1) according to any one of Claims 1 to 8, comprising a control integrated circuit assembled to the support and electrically connected to the nucleation conductive strips (6ᵢ) and the top conductive strips (14ⱼ), suitable for applying a potential difference, sequentially, to different subsets (Pᵢⱼ) of diodes (2), the one or more diodes (2) of a same subset (Pᵢⱼ) being in contact with a same nucleation conductive strip (6ᵢ) and a same top conductive strip (14ⱼ), the one or more diodes (2) of different subsets of diodes being in contact with different nucleation conductive strips (6ᵢ) and/or different top conductive strips (14ⱼ).

10. Optoelectronic device (1) according to any one of Claims 1 to 9, wherein at least one diode (2ᵢⱼ) in contact with a first nucleation conductive strip (6ᵢ) and a first top conductive strip (14ⱼ) is connected in series with at least one other diode (2_{i'j'}), the latter being in contact with a second nucleation conductive strip (6_{i'≠i}) distinct from the first nucleation strip (6ᵢ) and a second top conductive strip (14_{j'≠j}) distinct from the first top strip (14ⱼ).

11. Optoelectronic device (1) according to any one of Claims 1 to 10, wherein the support is composed of a substrate (4) made of a monocrystalline material that forms a top surface (4b), on which rests a so-called bottom insulating layer (5) made of a dielectric material epitaxially grown from the top surface (4b) of the substrate and forming an opposing top surface (5b), the nucleation conductive strips (6ᵢ) being made of a material comprising a transition metal forming a crystalline nucleation material, epitaxially grown from the top surface (5b) of the bottom insulating layer (5) and forming a nucleation surface (6bᵢ) on which the first doped regions (9) of said diodes (2) are in contact.

12. Optoelectronic device (1) according to Claim 11, wherein the material of the bottom insulating layer (5) is selected from aluminum nitride and oxides of aluminum, titanium, hafnium, magnesium and zirconium, and has a hexagonal, face-centered cubic, or orthorhombic crystalline structure.

13. Optoelectronic device (1) according to Claim 11 or 12, wherein the material of the nucleation conductive strips (6ᵢ) is selected from titanium, vanadium, chromium, zirconium, niobium, molybdenum, hafnium, tantalum and tungsten, or from a nitride or a carbide of titanium, vanadium, chromium, zirconium, niobium, molybdenum, hafnium, tantalum and tungsten, and has a hexagonal or face-centered cubic crystalline structure, or is a gallium-nitride-based material.

14. Optoelectronic device (1) according to any one of Claims 11 to 13, wherein the monocrystalline material of the substrate (4) is selected from a group III-V compound, a group II-VI compound, or a group IV element or compound and has a hexagonal or face-centered cubic crystalline structure.

15. Method for producing the optoelectronic device (1) according to any one of Claims 1 to 14, comprising a step of epitaxial growth of the nucleation conductive strips (6ᵢ) by sputtering at a growth temperature between room temperature and 500°C.
